# EUROPEAN PATENT APPLICATION

(11) **EP 4 632 813 A2**
(43) Date of publication of application: **15.10.2025**
(21) Application number: 25161237.0
(22) Date of filing: 03.03.2025
(51) Int. Cl.: H01L 25/065, H01L 23/31

(54) **MOLDED SEMICONDUCTOR PACKAGE WITH STACKED SEMICONDUCTOR CHIPS**

(30) Priority: 01.04.2024 KR 20240044098
(71) Applicant: Samsung Electronics Co., Ltd., Suwon-si, Gyeonggi-do 16677 (KR)
(72) Inventor: NOH, Hyunggyun, 16677 Suwon-si, Gyeonggi-do (KR); PAE, Sangwoo, 16677 Suwon-si, Gyeonggi-do (KR); BAE, Jinsoo, 16677 Suwon-si, Gyeonggi-do (KR)
(74) Representative: Kuhnen & Wacker Patent- und Rechtsanwaltsbüro PartG mbB

(57) **Abstract**

An example semiconductor package includes a first semiconductor chip, second semiconductor chips stacked on the first semiconductor chip in a vertical direction, a bonding layer between the second semiconductor chips, and a molding member on the first semiconductor chip and covering sidewalls of the second semiconductor chips and the bonding layer. A trench is positioned on at least one of the second semiconductor chips. The bonding layer at least partially fills the trench.

## Description

### BACKGROUND

A high bandwidth memory (HBM) package may include a plurality of memory chips stacked on a logic chip in a vertical direction, and the memory chips may be bonded with each other by a bonding layer. If the bonding state between the memory chips is good, the HBM package may have enhanced performance, and thus a method of enhancing the bonding state between the memory chips has been studied.

### SUMMARY

The present disclosure relates to semiconductor packages, including a semiconductor package having enhanced electrical characteristics.

In general, according to some aspects, a semiconductor package may include a first semiconductor chip, second semiconductor chips stacked on the first semiconductor chip in a vertical direction, a bonding layer between the second semiconductor chips, and a molding member on the first semiconductor chip and covering sidewalls of the second semiconductor chips and the bonding layer. The trench may be formed on at least one of the second semiconductor chips. The bonding layer may at least partially fill the trench.

In general, according to some aspects, a semiconductor package may include a first semiconductor chip, second semiconductor chips stacked on the first semiconductor chip in a vertical direction, a bonding layer between the second semiconductor chips, and a molding member on the first semiconductor chip and covering sidewalls of the second semiconductor chips and the bonding layer. At least one of the second semiconductor chips may include a dummy pad including a non-conductive material having a coefficient of thermal expansion (CTE) less than that of the bonding layer on the at least one of the second semiconductor chips. The bonding layer may cover the dummy pad.

In general, according to some aspects, a semiconductor package may include a buffer die, core dies stacked on the buffer die in a vertical direction, a bonding layer between the core dies, and a molding member on the buffer die and covering sidewalls of the core dies and the bonding layer. A trench may be formed on a first core die of the core dies. The bonding layer may at least partially fill the trench. A second core die of the core dies may include a dummy pad including a non-conductive material having a coefficient of thermal expansion (CTE) less than that of the bonding layer on the second core die. The bonding layer may cover the dummy pad.

The semiconductor package in accordance with example implementations may include the trench or the dummy pad on the edge portion of each of the semiconductor chips that are stacked in the vertical direction and bonded with each other by the bonding layer, and the trench or the dummy pad may disperse the stress applied to the edge portion of each of the semiconductor chips so that the cracks may not be generated.

### BRIEF DESCRIPTION OF THE DRAWINGS

FIGS. 1 and 2 are a cross-sectional view and a plan view illustrating an example of a semiconductor package.
FIGS. 3 to 10 are cross-sectional views and a plan view illustrating an example of a method of manufacturing a semiconductor package.
FIG. 11 is a cross-sectional view illustrating an example of a semiconductor package.
FIGS. 12 to 14 are plan views illustrating example layouts of trenches at each of the semiconductor chips.
FIGS. 15 and 16 are a cross-sectional view and a plan view illustrating an example of a semiconductor package.
FIGS. 17 and 18 are a cross-sectional view and a plan view illustrating an example of a method of manufacturing a semiconductor package.
FIGS. 19 and 20 are plan views illustrating example layouts of dummy pads at each of the semiconductor chips.
FIG. 21 is a cross-sectional view illustrating an example of a semiconductor package.
FIG. 22 is bar graphs illustrating magnitudes of stresses applied to each semiconductor chip in example semiconductor packages.
FIG. 23 is a cross-sectional view illustrating an example of an electronic device.

### DETAILED DESCRIPTION

Hereinafter, example implementations will be explained in detail with reference to the accompanying drawings.

Hereinafter, a direction substantially parallel to an upper surface of a wafer or a substrate may be referred to as a horizontal direction, and a direction substantially perpendicular to the upper surface of the wafer or the substrate may be referred to as a vertical direction.

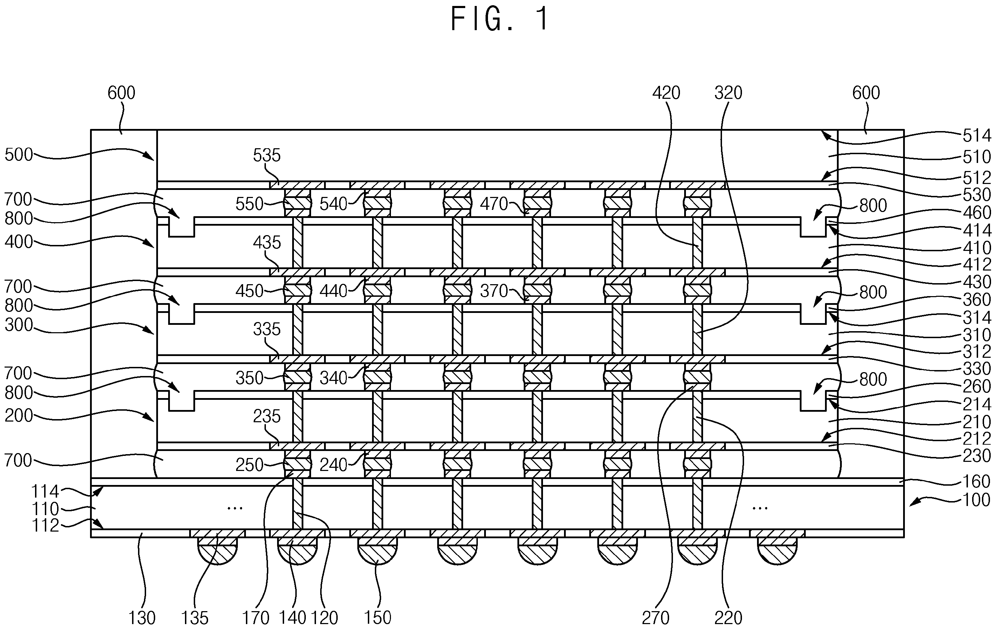

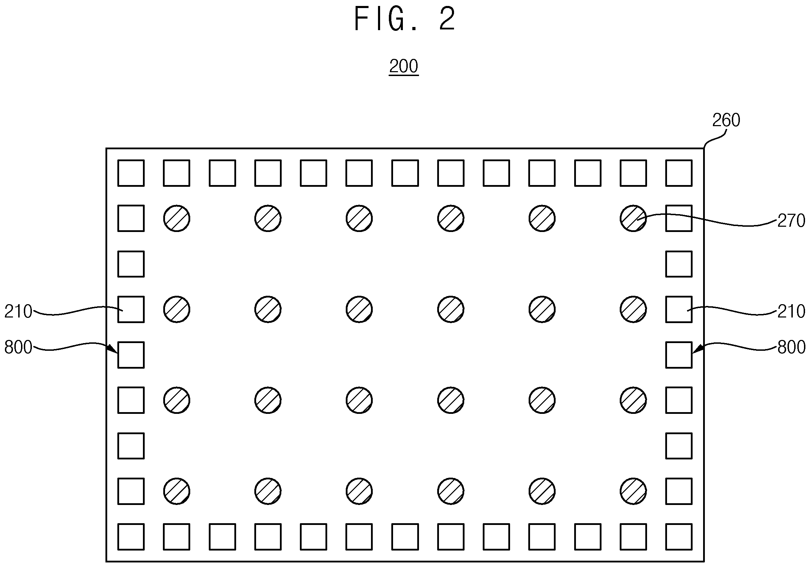

FIGS. 1 and 2 are a cross-sectional view and a plan view illustrating an example of a semiconductor package. Particularly, FIG. 2 is a drawing of a second chip included in the semiconductor package.

Referring to FIGS. 1 and 2, the semiconductor package may include a first semiconductor chip 100, second to fifth semiconductor chips 200, 300, 400 and 500 sequentially stacked on the first semiconductor chip 100, a bonding layer 700 between the first to fifth semiconductor chips 100, 200, 300, 400 and 500, and a molding member on the first semiconductor chip 100 and covering sidewalls of the second to fifth semiconductor chips 200, 300, 400 and 500.

FIGS. 1 and 2 show that the semiconductor package includes four semiconductor chips 200, 300, 400 and 500 stacked on the first semiconductor chip 100, however, the present disclosure may not be limited thereto, and the semiconductor package may include more than four semiconductor chips, e.g., eight or sixteenth semiconductor chips. In some implementations, the semiconductor package may be a high bandwidth memory (HBM) package.

In some implementations, the first semiconductor chip 100 may be a buffer die, and may include a logic device, e.g., a controller. Each of the second to fifth semiconductor chips 200, 300, 400 and 500 may be a core die, and may include a volatile memory device, e.g., a DRAM device, an SRAM device, etc., or a non-volatile memory device, e.g., a flash memory device, an EEPROM device, etc. Each of the second to fourth semiconductor chips 200, 300 and 400 may also be referred to as a middle core die, and the fifth semiconductor chip 500 may also be referred to as a top core die.

Additionally, the first semiconductor chip 100 may also be referred to as a logic chip or logic die, and each of the second to fifth semiconductor chips 200, 300, 400 and 500 may also be referred to as a memory chip or a memory die.

The first semiconductor chip 100 may include a first substrate 110 having first and second surfaces 112 and 114 opposite to each other in the vertical direction, a first through electrode structure 120 extending through the first substrate 110, a first insulating interlayer and a second insulating interlayer 130 sequentially stacked in the vertical direction beneath the first surface 112 of the first substrate 110, a first conductive pad 140 beneath the second insulating interlayer 130, a first conductive connection member 150 beneath the first conductive pad 140, a first protective pattern structure 160 on the second surface 114 of the first substrate 110, and a second conductive pad 170 on the first protective pattern structure 160 and contacting an upper surface of the first through electrode structure 120.

The first substrate 110 may include a semiconductor material, e.g., silicon, germanium, silicon-germanium, or a III-V group compound semiconductor, e.g., GaP, GaAs, GaSb, etc. In some implementations, the first substrate 110 may be a silicon-on-insulator (SOI) substrate or a germanium-on-insulator (GOI) substrate.

A circuit device, e.g., a logic device may be disposed beneath the first surface 112 of the first substrate 110. The circuit device may include circuit patterns, which may be covered by the first insulating interlayer.

The second insulating interlayer 130 may contain a first wiring structure 135 therein. The first wiring structure 135 may include, e.g., wirings, vias, contact plugs, etc., and FIG. 1 shows only a single layer for the first wiring structure 135 in order to avoid the complexity of the drawing.

The first insulating interlayer and the second insulating interlayer 130 may include, e.g., silicon oxide or a low-k dielectric material, e.g., an oxide doped with carbon or fluorine. The wirings, the vias, the contact plugs, etc., may include a conductive material, e.g., a metal, a metal nitride, a metal silicide, etc.

The first conductive pad 140 may be disposed under the second insulating interlayer 130, and may contact the first wiring structure 135 to be electrically connected thereto. In some implementations, a plurality of first conductive pads 140 may be spaced apart from each other in the horizontal direction.

In some implementations, the first conductive pad 140 may include a first seed pattern and first and second conductive patterns sequentially stacked downwardly in the vertical direction from the second insulating interlayer 130. The first seed pattern may include, e.g., titanium, and the first and second conductive patterns may include, e.g., nickel and copper, respectively.

The first conductive connection member 150 may contact a lower surface of the first conductive pad 140. The first conductive connection member 150 may be, e.g., a conductive bump. The first conductive connection member 150 may include a metal, e.g., tin, or solder that is a tin alloy such as tin/silver, tin/copper, tin/indium, tin/silver/copper, etc.

The first through electrode structure 120 may extend through the first substrate 110 in the vertical direction. A portion of the first through electrode structure 120 may protrude upwardly in the vertical direction, which may be referred to as a protrusion portion, and a sidewall of the protrusion portion of the first through electrode structure 120 may be covered by the first protective pattern structure 160. A plurality of first through electrode structures 120 may be spaced apart from each other in the horizontal direction. In some implementations, the first through electrode structure 120 may include a first through electrode extending in the vertical direction, a first barrier pattern covering a sidewall of the first through electrode, and a first insulation pattern covering an outer sidewall of the first barrier pattern. However, in some implementations, the first insulation pattern may not cover an upper portion of the outer sidewall of the first barrier pattern.

The first through electrode may include a metal, e.g., copper, aluminum, etc., the first barrier pattern may include a metal nitride, e.g., titanium nitride, tantalum nitride, etc., and the first insulation pattern may include an oxide, e.g., silicon oxide or an insulating nitride, e.g., silicon nitride.

In some implementations, the first through electrode structure 120 may extend through the first protective pattern structure 160, the first substrate 110 and the first insulating interlayer to contact the first wiring structure 135, and may be electrically connected to the first conductive pad 140 by the first wiring structure 135.

Alternatively, the first through electrode structure 120 may extend through the first protective pattern structure 160, the first substrate 110, the first insulating interlayer and the second insulating interlayer 130 to contact the first conductive pad 140, and may be electrically connected thereto. Alternatively, the first through electrode structure 120 may extend through the first protective pattern structure 160 and the first substrate 110 to contact one of the circuit patterns included in the circuit device covered by the first insulating interlayer, and may be electrically connected to the first conductive pad 140 by the one of the first circuit patterns and the first wiring structure 135.

The first protective pattern structure 160 may be disposed on the second surface 114 of the first substrate 110, and may surround the protrusion portion of the first through electrode structure 120. In some implementations, the first protective pattern structure 160 may contact an outer sidewall of an upper portion of the first barrier pattern of the first through electrode structure 120.

In some implementations, the first protective pattern structure 160 may include a first protective pattern and a second protective pattern sequentially stacked in the vertical direction on the second surface 114 of the first substrate 110. A portion of the first protective pattern adjacent to the first through electrode structure 120 may protrude upwardly in the vertical direction, and an upper surface of the portion of the first protective pattern 161 may be substantially coplanar with an upper surface of the first through electrode structure 120. An outer sidewall of the portion of the first protective pattern 161 may be covered by the second protective pattern.

The first protective pattern may include an oxide, e.g., silicon oxide, and the second protective pattern may include an insulating nitride, e.g., silicon nitride.

The second conductive pad 170 may be electrically connected to the first conductive pad 140 by the first through electrode structure 120 and the first wiring structure 135. In some implementations, a plurality of second conductive pads 170 may be spaced apart from each other in the horizontal direction.

In some implementations, the second conductive pad 170 may include a second seed pattern and third and fourth conductive patterns sequentially stacked upwardly in the vertical direction from the first protective pattern structure 160. The second seed pattern may include, e.g., titanium, and the third and fourth conductive patterns may include, e.g., nickel and gold, respectively.

The second semiconductor chip 200 may include a second substrate 210 having first and second surfaces 212 and 214 opposite to each other in the vertical direction, a second through electrode structure 220 extending through the second substrate 210, a third insulating interlayer and a fourth insulating interlayer 230 sequentially stacked in the vertical direction beneath the first surface 212 of the second substrate 210, a third conductive pad 240 beneath the fourth insulating interlayer 230, a second conductive connection member 250 beneath the third conductive pad 240, a second protective pattern structure 260 on the second surface 214 of the second substrate 210, and a fourth conductive pad 270 on the second protective pattern structure 260 and contacting an upper surface of the second through electrode structure 220.

The second substrate 210 may include a semiconductor material, e.g., silicon, germanium, silicon-germanium, or a III-V group compound semiconductor, e.g., GaP, GaAs, GaSb, etc. In some implementations, the second substrate 210 may be a silicon-on-insulator (SOI) substrate or a germanium-on-insulator (GOI) substrate.

A circuit device, e.g., a volatile memory device such as a DRAM device, an SRAM device, etc., or a non-volatile memory device such as a flash memory device, an EEPROM device, etc., may be disposed beneath the first surface 212 of the second substrate 210. The circuit device may include circuit patterns, which may be covered by the third insulating interlayer.

The fourth insulating interlayer 230 may contain a second wiring structure 235 therein. The second wiring structure 235 may include, e.g., wirings, vias, contact plugs, etc., and FIG. 1 shows only a single layer for the second wiring structure 235 in order to avoid the complexity of the drawing.

The third insulating interlayer and the fourth insulating interlayer 230 may include, e.g., silicon oxide or a low-k dielectric material, e.g., an oxide doped with carbon or fluorine. The wirings, the vias, the contact plugs, etc., may include a conductive material, e.g., a metal, a metal nitride, a metal silicide, etc.

The third conductive pad 240 may be disposed under the fourth insulating interlayer 230, and may contact the second wiring structure 235 to be electrically connected thereto. In some implementations, a plurality of third conductive pads 240 may be spaced apart from each other in the horizontal direction.

In some implementations, the third conductive pad 240 may include a third seed pattern and fifth and sixth conductive patterns sequentially stacked downwardly in the vertical direction from the fourth insulating interlayer 230. The third seed pattern may include, e.g., titanium, and the fifth and sixth conductive patterns may include, e.g., nickel and copper, respectively.

The second conductive connection member 250 may contact an upper surface of the second conductive pad 170 and a lower surface of the third conductive pad 240. The second conductive connection member 250 may be, e.g., a conductive bump. The second conductive connection member 250 may include a metal, e.g., tin, or solder.

The second through electrode structure 220 may extend through the second substrate 210 in the vertical direction. A portion of the second through electrode structure 220 may protrude upwardly in the vertical direction, which may be referred to as a protrusion portion, and a sidewall of the protrusion portion of the second through electrode structure 220 may be covered by the second protective pattern structure 260. A plurality of second through electrode structures 220 may be spaced apart from each other in the horizontal direction. In some implementations, the second through electrode structure 220 may include a second through electrode extending in the vertical direction, a second barrier pattern covering a sidewall of the second through electrode, and a second insulation pattern covering an outer sidewall of the second barrier pattern. However, in some implementations, the second insulation pattern may not cover an upper portion of the outer sidewall of the second barrier pattern.

The second through electrode may include a metal, e.g., copper, aluminum, etc., the second barrier pattern may include a metal nitride, e.g., titanium nitride, tantalum nitride, etc., and the second insulation pattern may include an oxide, e.g., silicon oxide or an insulating nitride, e.g., silicon nitride.

In some implementations, the second through electrode structure 220 may extend through the second protective pattern structure 260, the second substrate 210 and the third insulating interlayer to contact the second wiring structure 235, and may be electrically connected to the third conductive pad 240 by the second wiring structure 235.

Alternatively, the second through electrode structure 220 may extend through the second protective pattern structure 260, the second substrate 210 and the third insulating interlayer and the fourth insulating interlayer 230 to contact the third conductive pad 240, and may be electrically connected thereto. Alternatively, the second through electrode structure 220 may extend through the second protective pattern structure 260 and the second substrate 210 to contact one of the circuit patterns included in the circuit device covered by the third insulating interlayer, and may be electrically connected to the third conductive pad 240 by the one of the circuit patterns and the second wiring structure 235.

The second protective pattern structure 260 may be disposed on the second surface 214 of the second substrate 210, and may surround the protrusion portion of the second through electrode structure 220. In some implementations, the second protective pattern structure 260 may contact an outer sidewall of an upper portion of the second barrier pattern of the second through electrode structure 220.

In some implementations, the second protective pattern structure 260 may include a third protective pattern and a fourth protective pattern sequentially stacked in the vertical direction on the second surface 214 of the second substrate 210. A portion of the third protective pattern adjacent to the second through electrode structure 220 may protrude upwardly in the vertical direction, and an upper surface of the portion of the second protective pattern may be substantially coplanar with an upper surface of the second through electrode structure 220. An outer sidewall of the portion of the third protective pattern may be covered by the fourth protective pattern.

The third protective pattern may include an oxide, e.g., silicon oxide, and the fourth protective pattern may include an insulating nitride, e.g., silicon nitride.

The fourth conductive pad 270 may be electrically connected to the third conductive pad 240 by the second through electrode structure 220 and the second wiring structure 235. In some implementations, a plurality of fourth conductive pads 270 may be spaced apart from each other in the horizontal direction.

In some implementations, the fourth conductive pad 270 may include a fourth seed pattern and seventh and eighth conductive patterns sequentially stacked upwardly in the vertical direction from the second protective pattern structure 260. The fourth seed pattern may include, e.g., titanium, and the seventh and eighth conductive patterns may include, e.g., nickel and gold, respectively.

In some implementations, a trench 800 may be formed on a portion of the second substrate 210 adjacent to the second surface 214 thereof, that is, on an upper portion of the second substrate 210. In some implementations, a plurality of trenches 800 may be spaced apart from each other in the horizontal direction at an edge portion of the second semiconductor chip 200, which may be arranged in a ring shape and surround the fourth conductive pads 270 in a plan view. FIG. 2 shows that the trenches 800 are formed in a single column at each of the edge portions of the second semiconductor chip 200, however, the present disclosure may not be limited thereto, and in some implementations, the trenches 800 may be formed in a plurality of columns.

In some implementations, each of the trenches 800 may have a shape of, e.g., a polygon, a circle, an ellipse, a polygon with rounded corners, etc., however, the present disclosure may not be limited thereto.

The bonding layer 700 be disposed between the first and second semiconductor chips 100 and 200, and may bond the first and second semiconductor chips 100 and 200 with each other. The bonding layer 700 may surround the second and third conductive pads 170 and 240 and the second conductive connection member 250. In some implementations, the bonding layer 700 may have a convex sidewall. That is, a sidewall of the bonding layer 700 may not be aligned with a sidewall of the second semiconductor chip 200, but a central portion of the sidewall of the bonding layer 700 may protrude outwardly.

The bonding layer 700 may include, e.g., non-conductive film (NCF) or die attach film (DAF).

The third to fifth semiconductor chips 300, 400 and 500 may be sequentially stacked in the vertical direction on the second semiconductor chip 200, and the bonding layer 700 may be disposed therebetween. In some implementations, the bonding layer 700 may have a convex sidewall. That is, a sidewall of the bonding layer 700 may not be aligned with a sidewall of each of the third to fifth semiconductor chips 200, 400 and 500, but a central portion of the sidewall of the bonding layer 700 may protrude outwardly.

Each of the third to fifth semiconductor chips 300, 400 and 500 may have a structure substantially the same as or similar to that of the second semiconductor chip 200, and thus the third to fifth semiconductor chips 300, 400 and 500 are described briefly.

The third semiconductor chip 300 may include a third substrate 310 having first and second surfaces 312 and 314 opposite to each other in the vertical direction, a third through electrode structure 320 extending through the third substrate 310, a fifth insulating interlayer and a sixth insulating interlayer 330 sequentially stacked in the vertical direction beneath the first surface 312 of the third substrate 310, a fifth conductive pad 340 beneath the sixth insulating interlayer 330, a third conductive connection member 350 beneath the fifth conductive pad 340, a third protective pattern structure 360 on the second surface 314 of the third substrate 310, and a sixth conductive pad 370 on the third protective pattern structure 360 and contacting an upper surface of the third through electrode structure 320.

A circuit device, e.g., a memory device may be disposed beneath the first surface 312 of the third substrate 310. The circuit device may include circuit patterns, which may be covered by the fifth insulating interlayer. The sixth insulating interlayer 330 may contain a third wiring structure 335 therein.

The fifth conductive pad 340 may be disposed under the sixth insulating interlayer 330, and may contact the third wiring structure 335 to be electrically connected thereto. In some implementations, a plurality of fifth conductive pads 340 may be spaced apart from each other in the horizontal direction.

In some implementations, the fifth conductive pad 340 may include a fifth seed pattern and ninth and tenth conductive patterns sequentially stacked downwardly in the vertical direction from the sixth insulating interlayer 330. The fifth seed pattern may include, e.g., titanium, and the ninth and tenth conductive patterns may include, e.g., nickel and copper, respectively.

The third conductive connection member 350 may contact an upper surface of the fourth conductive pad 270 and a lower surface of the fifth conductive pad 340.

The third through electrode structure 320 may extend through the third substrate 310 in the vertical direction. A portion of the third through electrode structure 320 may protrude upwardly in the vertical direction, which may be referred to as a protrusion portion, and may be covered by the third protective pattern structure 360. A plurality of third through electrode structures 320 may be spaced apart from each other in the horizontal direction. In some implementations, the third through electrode structure 320 may include a third through electrode extending in the vertical direction, a third barrier pattern covering a sidewall of the third through electrode, and a third insulation pattern covering an outer sidewall of the third barrier pattern. However, in some implementations, the third insulation pattern may not cover an upper portion of the outer sidewall of the third barrier pattern.

In some implementations, the third through electrode structure 320 may extend through the third protective pattern structure 360, the third substrate 310 and the fifth insulating interlayer to contact the third wiring structure 335, and may be electrically connected to the fifth conductive pad 340 by the third wiring structure 335.

The third protective pattern structure 360 may be disposed on the second surface 314 of the third substrate 310, and may surround a sidewall of the protrusion portion of the third through electrode structure 320. In some implementations, the third protective pattern structure 360 may contact an outer sidewall of an upper portion of the third barrier pattern of the third through electrode structure 320.

In some implementations, the third protective pattern structure 360 may include a fifth protective pattern and a sixth protective pattern sequentially stacked in the vertical direction on the second surface 314 of the third substrate 310. A portion of the fifth protective pattern adjacent to the third through electrode structure 320 may protrude upwardly in the vertical direction, and an upper surface of the portion of the fifth protective pattern may be substantially coplanar with an upper surface of the third through electrode structure 320. An outer sidewall of the portion of the fifth protective pattern may be covered by the sixth protective pattern.

The fifth protective pattern may include an oxide, e.g., silicon oxide, and the sixth protective pattern may include an insulating nitride, e.g., silicon nitride.

The sixth conductive pad 370 may be electrically connected to the fifth conductive pad 340 by the third through electrode structure 320 and the third wiring structure 335. In some implementations, the sixth conductive pad 370 may include a sixth seed pattern and eleventh and twelfth conductive patterns sequentially stacked upwardly in the vertical direction from the third protective pattern structure 360. The sixth seed pattern may include, e.g., titanium, and the eleventh and twelfth conductive patterns may include, e.g., nickel and gold, respectively.

In some implementations, the trench 800 may be formed on a portion of the third substrate 310 adjacent to the second surface 314 thereof, that is, on an upper portion of the third substrate 310. In some implementations, a plurality of trenches 800 may be spaced apart from each other in the horizontal direction at an edge portion of the third semiconductor chip 300, which may be arranged in a ring shape in a plan view.

The bonding layer 700 may be disposed between the second and third semiconductor chips 200 and 300, and may surround the fourth and fifth conductive pads 270 and 340 and the third conductive connection member 350. In some implementations, the bonding layer 700 may fill the trench 800 on the second substrate 210.

The fourth semiconductor chip 400 may include a fourth substrate 410 having first and second surfaces 412 and 414 opposite to each other in the vertical direction, a fourth through electrode structure 420 extending through the fourth substrate 410, a seventh insulating interlayer and an eighth insulating interlayer 430 sequentially stacked in the vertical direction beneath the first surface 412 of the fourth substrate 410, a seventh conductive pad 440 beneath the eighth insulating interlayer 430, a fourth conductive connection member 450 beneath the seventh conductive pad 440, a fourth protective pattern structure 460 on the second surface 414 of the fourth substrate 410, and an eighth conductive pad 470 on the fourth protective pattern structure 460 and contacting an upper surface of the fourth through electrode structure 420.

A circuit device, e.g., a memory device may be disposed beneath the first surface 412 of the fourth substrate 410. The circuit device may include circuit patterns, which may be covered by the seventh insulating interlayer. The eighth insulating interlayer 430 may contain a fourth wiring structure 435 therein.

The seventh conductive pad 440 may be disposed under the eighth insulating interlayer 430, and may contact the fourth wiring structure 435 to be electrically connected thereto. In some implementations, a plurality of seventh conductive pads 440 may be spaced apart from each other in the horizontal direction.

In some implementations, the seventh conductive pad 440 may include a seventh seed pattern and thirteenth and fourteenth conductive patterns sequentially stacked downwardly in the vertical direction from the eighth insulating interlayer 430. The seventh seed pattern may include, e.g., titanium, and the thirteenth and fourteenth conductive patterns may include, e.g., nickel and copper, respectively.

The fourth conductive connection member 450 may contact an upper surface of the sixth conductive pad 370 and a lower surface of the seventh conductive pad 440.

The fourth through electrode structure 420 may extend through the fourth substrate 410 in the vertical direction. A portion of the fourth through electrode structure 420 may protrude upwardly in the vertical direction, which may be referred to as a protrusion portion, and a sidewall of the protrusion portion of the fourth through electrode structure 420 may be covered by the fourth protective pattern structure 460. A plurality of fourth through electrode structures 420 may be spaced apart from each other in the horizontal direction. In some implementations, the fourth through electrode structure 420 may include a fourth through electrode extending in the vertical direction, a fourth barrier pattern covering a sidewall of the fourth through electrode, and a fourth insulation pattern covering an outer sidewall of the fourth barrier pattern. However, in some implementations, the fourth insulation pattern may not cover an upper portion of the outer sidewall of the fourth barrier pattern.

In some implementations, the fourth through electrode structure 420 may extend through the fourth protective pattern structure 460, the fourth substrate 410 and the seventh insulating interlayer to contact the fourth wiring structure, and may be electrically connected to the seventh conductive pad 440 by the fourth wiring structure 435.

The fourth protective pattern structure 460 may be disposed on the second surface 414 of the fourth substrate 410, and may surround a sidewall of the protrusion portion of the fourth through electrode structure 420. In some implementations, the fourth protective pattern structure 460 may contact an outer sidewall of an upper portion of the fourth barrier pattern of the fourth through electrode structure 420.

In some implementations, the fourth protective pattern structure 460 may include a seventh protective pattern and an eighth protective pattern sequentially stacked in the vertical direction on the second surface 414 of the fourth substrate 410. A portion of the seventh protective pattern adjacent to the fourth through electrode structure 420 may protrude upwardly in the vertical direction, and an upper surface of the portion of the seventh protective pattern may be substantially coplanar with an upper surface of the fourth through electrode structure 420. An outer sidewall of the portion of the seventh protective pattern may be covered by the eighth protective pattern.

The seventh protective pattern may include an oxide, e.g., silicon oxide, and the eighth protective pattern may include an insulating nitride, e.g., silicon nitride.

The eighth conductive pad 470 may be electrically connected to the seventh conductive pad 440 by the fourth through electrode structure 420 and the fourth wiring structure. In some implementations, a plurality of eighth conductive pads 470 may be spaced apart from each other in the horizontal direction. In some implementations, the eighth conductive pad 470 may include an eighth seed pattern and fifteenth and sixteenth conductive patterns sequentially stacked upwardly in the vertical direction from the fourth protective pattern structure 460. The eighth seed pattern may include, e.g., titanium, and the fifteenth and the sixteenth conductive patterns may include, e.g., nickel and gold, respectively.

In some implementations, the trench 800 may be formed on a portion of the fourth substrate 410 adjacent to the second surface 414 thereof, that is, on an upper portion of the third substrate 410. In some implementations, a plurality of trenches 800 may be spaced apart from each other in the horizontal direction at an edge portion of the fourth semiconductor chip 400, which may be arranged in a ring shape in a plan view.

The bonding layer 700 may be disposed between the third and fourth semiconductor chips 300 and 400, and may surround the sixth and seventh conductive pads 370 and 440 and the fourth conductive connection member 450. In some implementations, the bonding layer 700 may fill the trench 800 on the third substrate 310.

The fifth semiconductor chip 500 may include a fifth substrate 510 having first and second surfaces 512 and 514 opposite to each other in the vertical direction, a ninth insulating interlayer and a tenth insulating interlayer 530 sequentially stacked in the vertical direction beneath the first surface 512 of the fifth substrate 510, a ninth conductive pad 540 beneath the tenth insulating interlayer 530 and a fifth conductive connection member 550 beneath the ninth conductive pad 540.

A circuit device, e.g., a memory device may be disposed beneath the first surface 512 of the fifth substrate 510. The circuit device may include circuit patterns, which may be covered by the ninth insulating interlayer. The tenth insulating interlayer 530 may contain a fifth wiring structure 535 therein.

The ninth conductive pad 540 may be disposed under the tenth insulating interlayer 530, and may contact the fifth wiring structure 535 to be electrically connected thereto. In some implementations, a plurality of ninth conductive pads 540 may be spaced apart from each other in the horizontal direction.

In some implementations, the ninth conductive pad 540 may include a ninth seed pattern and seventeenth and eighteenth conductive patterns sequentially stacked downwardly in the vertical direction from the tenth insulating interlayer 530. The ninth seed pattern may include, e.g., titanium, and the seventeenth and eighteenth conductive patterns may include, e.g., nickel and copper, respectively.

The fifth conductive connection member 550 may contact an upper surface of the eighth conductive pad 470 and a lower surface of the ninth conductive pad 540.

The bonding layer 700 may be disposed between the fourth and fifth semiconductor chips 400 and 500, and may bond the fourth and fifth semiconductor chips 400 and 500 with each other, and may surround the eighth and ninth conductive pads 470 and 540 and the fifth conductive connection member 550.

The first to fifth semiconductor chips 100, 200, 300, 400 and 500 may be electrically connected to each other by the first to fourth through electrodes 120, 220, 320 and 420 extending through the first to fourth substrates 110, 210, 310 and 410, respectively, the first to fifth wiring structures 135, 235, 335, 435 and 535 electrically connected thereto, the first to ninth conductive pads 140, 170, 240, 270, 340, 370, 440, 470 and 540 electrically connected thereto, and the second to fifth conductive connection members 250, 350, 450 and 550 electrically connected thereto, and electrical signals, e.g., data signals, control signals, etc., may be transferred to each other.

Additionally, electrical signals may be transferred from the first conductive pad 140 to an external device through the first conductive connection member 150.

The molding member 600 may cover sidewalls of the second to fifth semiconductor chips 200, 300, 400 and 500 and sidewalls of the bonding layers 700 on the first semiconductor chip 100, and upper surface of the molding member 600 may be substantially coplanar with an upper surface of the fifth semiconductor chip 500. The molding member 600 may include a polymer, e.g., epoxy molding compound (EMC).

In the semiconductor package, the first to fifth semiconductor chips 100, 200, 300, 400 and 500 may communicate with each other through the second to fifth conductive connection members 250, 350, 450 and 550. For example, the second conductive connection member 250 may be disposed between and contact the second and third conductive pads 170 and 240 of the first and second semiconductor chips 100 and 200, respectively, and thus may serve as an electrical signal path. Additionally, the third conductive connection member 350 may be disposed between and contact the fourth and fifth conductive pads 270 and 340 of the second and third semiconductor chips 200 and 300, respectively, and thus may serve as an electrical signal path.

In the semiconductor package, each of the bonding layers 700 may surround a corresponding one of the second to fifth conductive connection members 250, 350, 450 and 550, and may be disposed between neighboring ones of the first to fifth semiconductor chips 100, 200, 300, 400 and 500 to bond the first to fifth semiconductor chips 100, 200, 300, 400 and 500 with each other.

The first to fifth substrates 110, 210, 310, 410 and 510 included in the first to fifth semiconductor chips 100, 200, 300, 400 and 500, respectively, may include, e.g., silicon, each of the bonding layers 700 between neighboring ones of the first to fifth semiconductor chips 100, 200, 300, 400 and 500 may include, e.g., NCF or DAF, and the molding member 600 on the first semiconductor chip 100 and covering sidewalls of the second to fifth semiconductor chips 200, 300, 400 and 500 and the bonding layers 700 may include, e.g., EMC.

These materials may have different coefficients of thermal expansion (CTE) from each other, and particularly, NCF or DAF may have a CTE, which may be about 3.47 × 10⁻⁵, greater than that of EMC or silicon. Thus, when the semiconductor package is exposed to a high temperature, NCF or DAF may expand more than EMC or silicon so that stress may be concentrated at an interface between each of the second to fourth semiconductor chips 200, 300 and 400 and the bonding layer 700 and an interface between the bonding layer 700 and the molding member 600.

Particularly, cracks may be generated at an upper edge portion of each of the second to fourth semiconductor chips 200, 300 and 400, or delamination may occur at the interface between each of the second to fourth semiconductor chips 200, 300 and 400 and the bonding layer 700 and the interface between the bonding layer 700 and the molding member 600.

However, in some implementations, the trench 800 may be formed at the upper edge portion of each of the second to fourth semiconductor chips 200, 300 and 400, and thus, when the semiconductor package is exposed to a high temperature, even if the bonding layer 700 including NCF or DAF excessively expands, stress may not be concentrated at the upper portion of each of the second to fourth semiconductor chips 200, 300 and 400, but the trench 800 may partially absorb the stress. Accordingly, cracks may not be generated at the upper edge portion of each of the second to fourth semiconductor chips 200, 300 and 400.

FIGS. 1 and 2 show that the trench 800 is formed at each of the second to fourth semiconductor chips 200, 300 and 400, however, the present disclosure may not be limited thereto, and for example, the trench 800 may be formed only at some of the second to fourth semiconductor chips 200, 300 and 400.

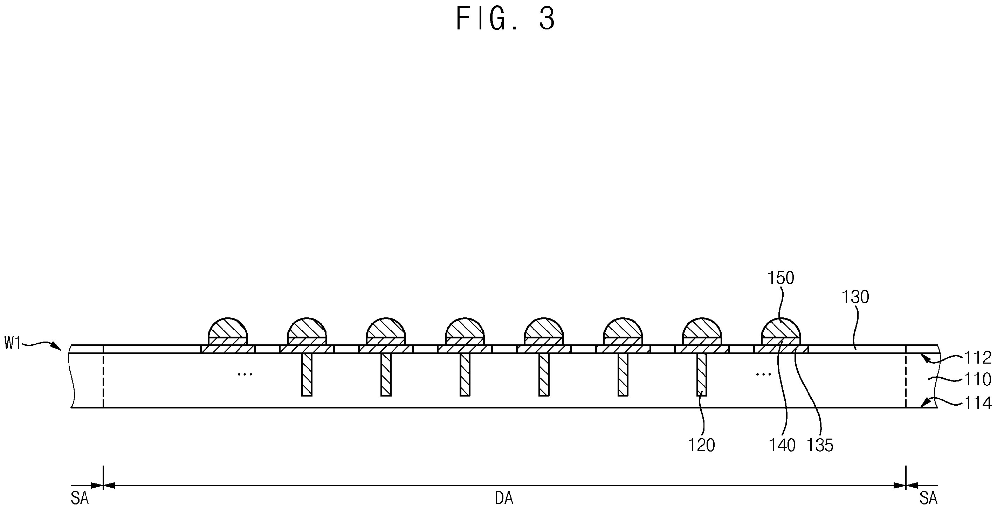

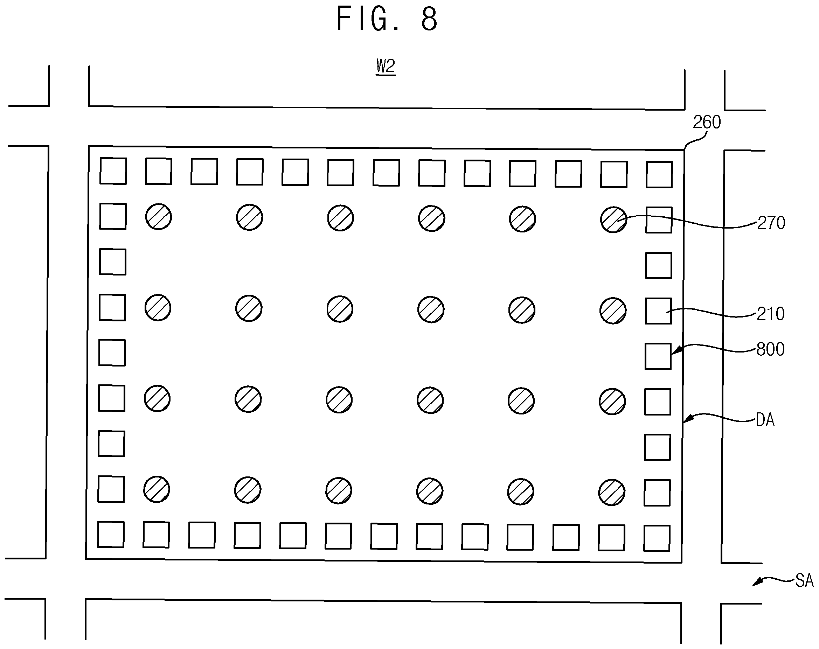

FIGS. 3 to 10 are cross-sectional views and a plan view illustrating an example of a method of manufacturing a semiconductor package. FIGS. 3-7 and 9-10 are the cross-sectional views, and FIG. 8 is the plan view.

Referring to FIG. 3, a first wafer W1 may be provided.

In some implementations, the first wafer W1 may include a first substrate 110 having first and second surfaces 112 and 114 opposite to each other in the vertical direction. Additionally, the first wafer W1 may include a plurality of die regions DA and a scribe lane region SA surrounding each of the die regions DA. The first wafer W1 may be cut along the scribe lane region SA by a sawing process to be singulated into a plurality of first semiconductor chips.

In the die region DA, a circuit device may be formed on the first surface 112 of the first substrate 110. The circuit device may include a logic device. The circuit device may include circuit patterns, and a first insulating interlayer may be formed on the first surface 112 of the first substrate 110 to cover the circuit patterns.

A second insulating interlayer 130 may be formed on the first insulating interlayer, and may contain a first wiring structure 135 therein. The first wiring structure 135 may include, e.g., wirings, vias, contact plugs, etc.

A first conductive pad 140 may be formed on second insulating interlayer 130 to contact the first wiring structure 135 to be electrically connected thereto. In some implementations, a plurality of first conductive pads 140 may be spaced apart from each other in the horizontal direction.

In some implementations, the first conductive pad 140 may be formed by following processes.

Particularly, a first seed layer may be formed on the second insulating interlayer 130, a first photoresist pattern including a first opening partially exposing an upper surface of the first seed layer may be formed on the first seed layer, and an electroplating process or an electroless plating process may be performed to form first and second conductive patterns in the first opening.

The first photoresist pattern may be removed by, e.g., an ashing process and/or a stripping process to expose a portion of the first seed layer, the exposed portion of the first seed layer may be removed to form a first seed pattern under the first conductive pattern.

Thus, the first conductive pad 140 including the first seed pattern and the first and second conductive patterns sequentially stacked in the vertical direction may be formed.

A first conductive connection member 150 may be formed on the first conductive pad 140.

In some implementations, the first conductive connection member 150 may be formed by following processes.

Particularly, a second photoresist pattern including a second opening exposing an upper surface of the first conductive pad 140 may be formed on the second insulating interlayer 130, and an electroplating process or an electroless plating process may be performed to form a preliminary first conductive connection member in the second opening. After removing the second photoresist pattern, a reflow process may be performed so that the preliminary first conductive connection member may be transformed into a first conductive connection member 150.

In some implementations, the first conductive connection member 150 may have, e.g., a hemispherical shape or a semioval shape.

In some implementations, a first through electrode structure 120 extending in the vertical direction through an upper portion of the first substrate 110, that is, a portion of the first substrate 110 adjacent to the first surface 112 thereof may be formed. In some implementations, a plurality of first through electrode structures 120 may be spaced apart from each other in the horizontal direction in each of the die regions DA of the first wafer W1.

In some implementations, the first through electrode structure 120 may include a first through electrode extending in the vertical direction, a first barrier pattern covering a sidewall and a lower surface of the first through electrode, and a first insulation pattern covering a sidewall and a lower surface of the first barrier pattern.

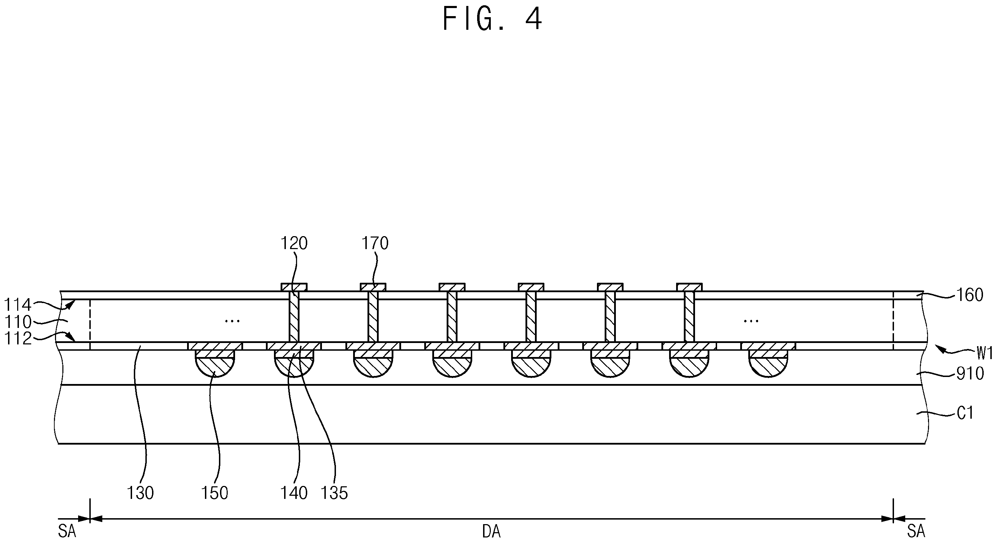

Referring to FIG. 4, a first temporary bonding layer 910 may be attached to a first carrier substrate C1, and the first temporary bonding layer 910 may be bonded with an upper surface of the second insulating interlayer 130 including the first wiring structure 135 to cover the first conductive connection member 150 and the first conductive pad 140 on the first wafer W1 so that the first carrier substrate C1 may be bonded with the first wafer W1.

The first temporary bonding layer 910 may include a material losing adhesion by irradiation of light, e.g., UV light or heat. In some implementations, the first temporary bonding layer 910 may include glue.

After flipping the first wafer W1, a portion of the first substrate 110 adjacent to the second surface 114 of the first substrate 110 may be removed by, e.g., a grinding process to expose an upper portion of the first through electrode structure 120.

In some implementations, an upper portion of the first insulation pattern of the first through electrode structure 120 may also be removed by the grinding process, and thus an upper outer sidewall of the first barrier pattern may be exposed.

A first protective layer structure may be formed on the second surface 114 of the first substrate 110 to cover the first through electrode structure 120, and a planarization process may be performed on the first protective layer structure until an upper surface of the first through electrode 125 of the first through electrode structure 120 is exposed to form a first protective pattern structure 160.

In some implementations, the planarization process may include a chemical mechanical polishing (CMP) process and/or an etch back process.

In some implementations, the first protective layer structure may include first to third protective layers sequentially stacked in the vertical direction, and during the planarization process, the third protective layer may be removed and the second protective layer may partially remain. Thus, the first protective pattern structure 160 may include first and second protective patterns sequentially stacked in the vertical direction. An upper outer sidewall of a portion of the first protective pattern adjacent to the first through electrode structure 120 may be covered by the second protective pattern.

A second conductive pad 170 may be formed on the first protective pattern structure 160 and the first through electrode structure 120. In some implementations, a plurality of second conductive pads 170 may be spaced apart from each other in the horizontal direction, and each of the second conductive pads 170 may contact an upper surface of the first through electrode structure 120 to be electrically connected thereto.

In some implementations, the second conductive pad 170 may be formed by following processes.

Particularly, a second seed layer may be formed on the first protective pattern structure 160 and the first through electrode structure 120, a third photoresist pattern including a third opening partially exposing an upper surface of the second seed layer may be formed on the second seed layer, and an electroplating process or an electroless plating process may be performed to form third and fourth conductive patterns in the third opening.

The third photoresist pattern may be removed by, e.g., an ashing process and/or a stripping process to expose a portion of the second seed layer, the exposed portion of the second seed layer may be removed to form a second seed pattern under the third conductive pattern.

Thus, a second conductive pad 170 including the second seed pattern and the third and fourth conductive patterns sequentially stacked in the vertical direction may be formed.

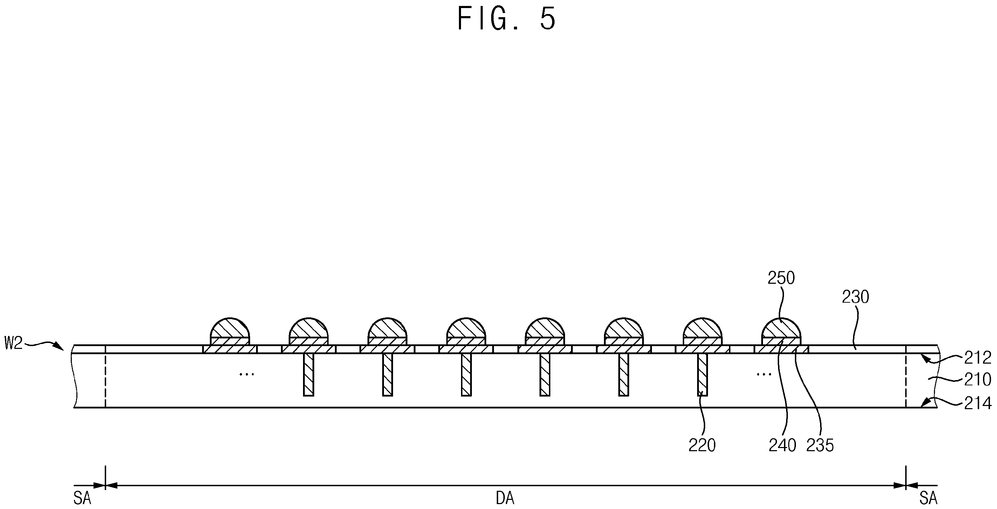

Referring to FIG. 5, a second wafer W2 may be provided.

In some implementations, the second wafer W2 may include a second substrate 210 having first and second surfaces 212 and 214 opposite to each other in the vertical direction. Additionally, the second wafer W2 may include a plurality of die regions DA and a scribe lane region SA surrounding each of the die regions DA. The second wafer W2 may be cut along the scribe lane region SA by a sawing process to be singulated into a plurality of second semiconductor chips.

In the die region DA, a circuit device may be formed on the first surface 212 of the second substrate 210. The circuit device may include a memory device. The circuit device may include circuit patterns, and a third insulating interlayer may be formed on the first surface 212 of the second substrate 210 to cover the circuit patterns.

A fourth insulating interlayer 230 may be formed on the third insulating interlayer, and may contain a second wiring structure 235 therein. The second wiring structure 235 may include, e.g., wirings, vias, contact plugs, etc.

A third conductive pad 240 may be formed on fourth insulating interlayer 230 to contact the second wiring structure 235 to be electrically connected thereto. In some implementations, a plurality of third conductive pads 240 may be spaced apart from each other in the horizontal direction.

In some implementations, the third conductive pad 240 may be formed by processes substantially the same as or similar to those of the first conductive pad 140. Thus, the third conductive pad 240 including a third seed pattern and the fifth and sixth conductive patterns sequentially stacked in the vertical direction may be formed.

A second conductive connection member 250 may be formed on the third conductive pad 240. In some implementations, the second conductive connection member 250 may be formed by processes substantially the same as or similar to those of the first conductive connection member 150. Thus, the second conductive connection member 250 may have, e.g., a hemispherical shape or a semioval shape.

In some implementations, a second through electrode structure 220 extending in the vertical direction through an upper portion of the second substrate 210, that is, a portion of the second substrate 210 adjacent to the first surface 212 thereof may be formed. In some implementations, a plurality of second through electrode structures 220 may be spaced apart from each other in the horizontal direction.

In some implementations, the second through electrode structure 220 may include a second through electrode extending in the vertical direction, a second barrier pattern covering a sidewall and a lower surface of the second through electrode, and a second insulation pattern covering a sidewall and a lower surface of the second barrier pattern.

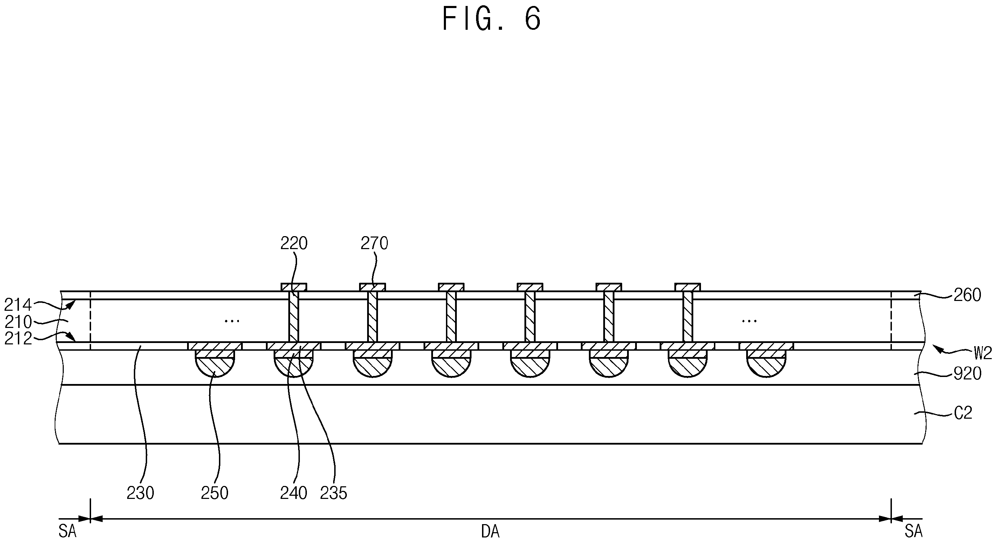

Referring to FIG. 6, processes substantially the same as or similar to those illustrated with respect to FIGS. 3 and 4 may be performed.

Thus, a second temporary bonding layer 920 may be attached to a second carrier substrate C2, and the second temporary bonding layer 920 may be bonded with an upper surface of the fourth insulating interlayer 230 including the second wiring structure 235 to cover the second conductive connection member 250 and the third conductive pad 240 on the second wafer W2 so that the second carrier substrate C2 may be bonded with the second wafer W2. The second temporary bonding layer 920 may include a material losing adhesion by irradiation of light, e.g., UV light or heat. In some implementations, the second temporary bonding layer 920 may include glue.

After flipping the second wafer W2, a portion of the second substrate 210 adjacent to the second surface 214 of the second substrate 210 may be removed by, e.g., a grinding process to expose an upper portion of the second through electrode structure 220, a second protective layer structure may be formed on the second surface 214 of the second substrate 210 to cover the second through electrode structure 220, and a planarization process may be performed on the second protective layer structure until an upper surface of the second through electrode 225 of the second through electrode structure 220 is exposed to form a second protective pattern structure 260. The second protective pattern structure 260 may include third and fourth protective patterns sequentially stacked in the vertical direction.

A fourth conductive pad 270 may be formed on the second protective pattern structure 260 and the second through electrode structure 220. The fourth conductive pad 270 may include a fourth seed pattern and seventh and eighth conductive patterns sequentially stacked in the vertical direction.

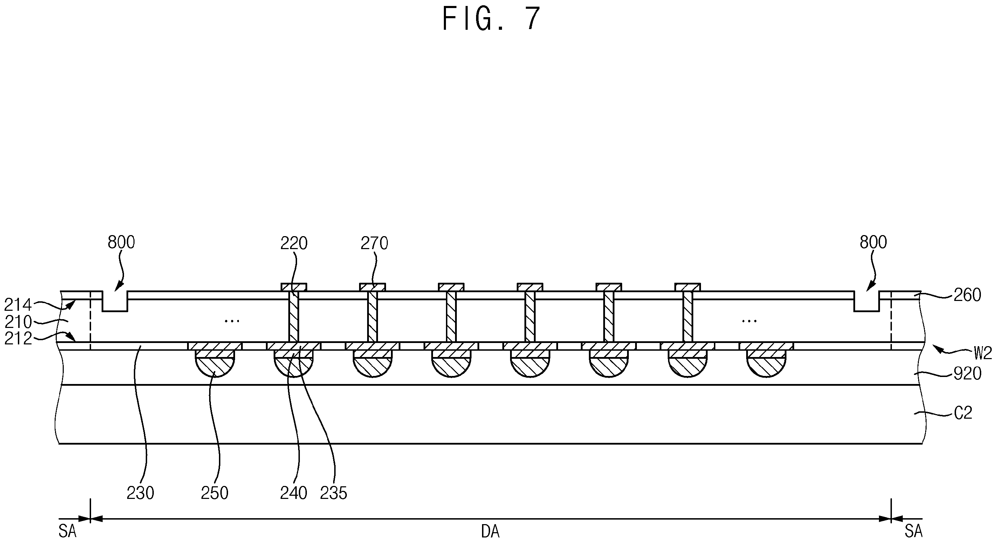

Referring to FIGS. 7 and 8, the second protective pattern structure 260 and a portion of the second wafer W2 adjacent to the second surface 214 thereof, that is, an upper portion of the second wafer W2 may be partially removed by an etching process to form a trench 800.

In some implementations, a plurality of trenches 800 may be spaced apart from each other in the horizontal direction at an edge portion of each of the die regions DA of the second wafer W2. In some implementations, the trenches 800 may be arranged in a ring shape in a plan view.

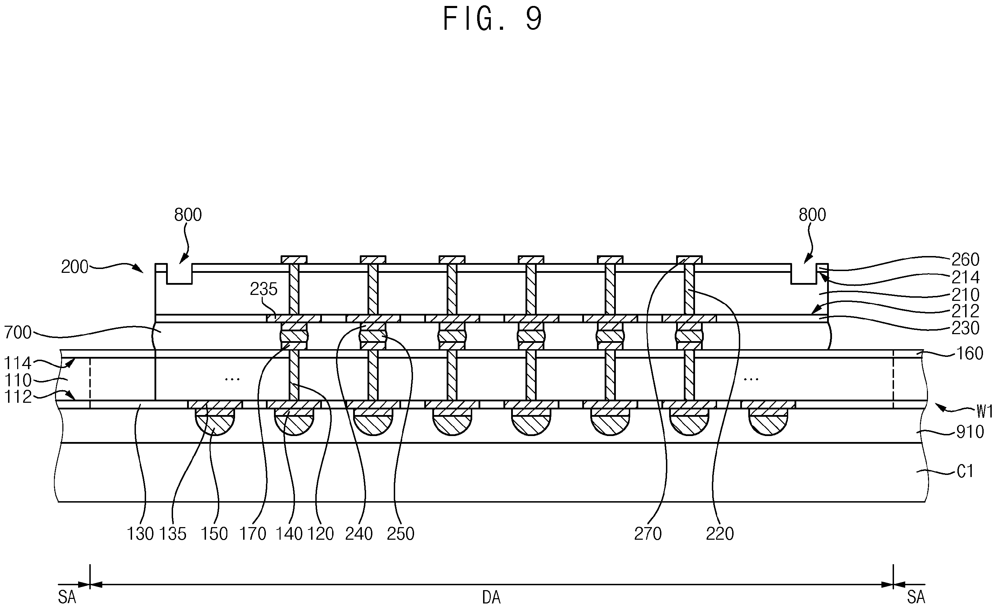

Referring to FIG. 9, after flipping the second wafer W2, the second wafer W2 may be attached to an upper surface of a release tape on a frame having a shape of, e.g., a ring.

The release tape may contact upper surfaces of the fourth conductive pad 270 and the second protective pattern structure 260 on the second surface 214 of the second wafer W2.

The second temporary bonding layer 920 attached to the second carrier substrate C2 may be separated from the second conductive connection member 250, the third conductive pad 240 and the fourth insulating interlayer 230 so that the second carrier substrate C2 may be separated from the second wafer W2.

After cutting the wafer W2 along the scribe lane region SA by a sawing process into second semiconductor chips 200, a bonding layer 700 may be formed on the fourth insulating interlayer 230 of each of the second semiconductor chips 200.

The bonding layer 700 may be formed on the fourth insulating interlayer 230 to cover the third conductive pad 240 and the second conductive connection member 250. The bonding layer 700 may include, e.g., NCF or DAF.

In some implementations, the bonding layer 700 may be formed on the fourth insulating interlayer 230 of the second wafer W2, before the sawing process.

Each of the second semiconductor chips 200 may be mounted on the first wafer W1 such that the bonding layer 700 on each of the semiconductor chips 200 may contact upper surfaces of the second conductive pad 170 and the first protective pattern structure 160 of the first wafer W1. The second semiconductor chips 200 may be disposed on the respective die regions DA of the first wafer W1, and the second conductive connection member 250 of the second semiconductor chip 200 may contact the upper surface of the second conductive pad 170 of the first semiconductor chip.

A thermal compression bonding (TCB) process may be performed at a temperature equal to or less than about 400°C so that the second semiconductor chips 200 may be bonded to the first wafer W1.

During the thermal compression process, NCF or DAF included in the bonding layer 700 may be melted to have fluidity, may flow into a space between each of the second semiconductor chips 200 and the first wafer W1, particularly, a space between the first protective pattern structure 160 of the first wafer W1 and the fourth insulating interlayer 230 of each of the second semiconductor chips 200 to cover a sidewall of a structure including the second conductive pad 170, the second conductive connection member 250 and the third conductive pad 240, and may be cured.

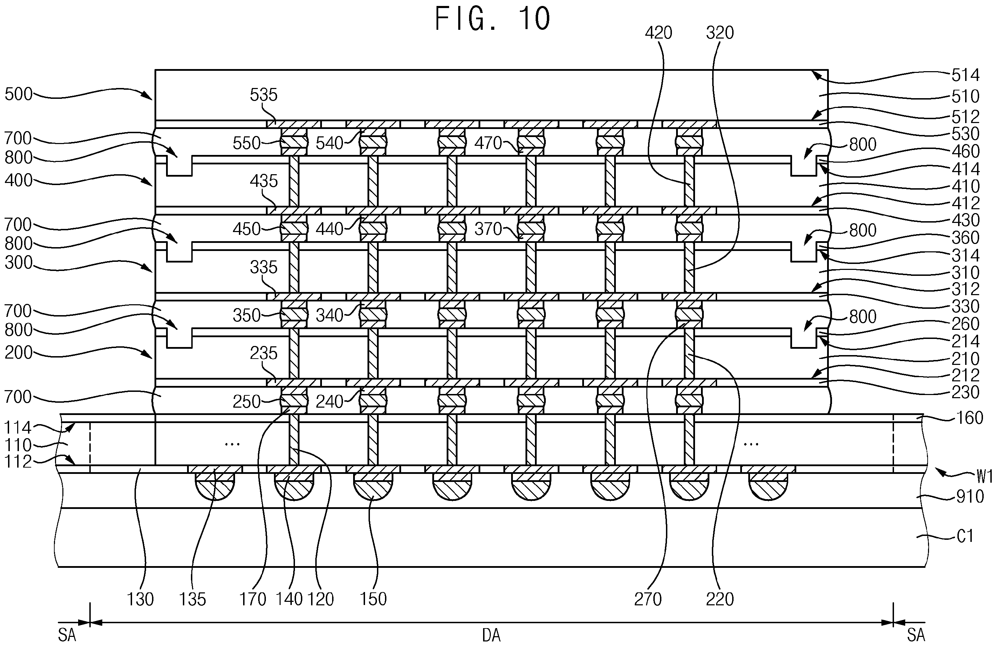

Referring to FIG. 10, third to fifth semiconductor chips 300, 400 and 500 may be sequentially stacked on the second semiconductor chip 200.

Processes substantially the same as or similar to those illustrated with respect to FIGS. 5 to 8 may be performed to form a plurality of third semiconductor chips 300, and trenches 800 may be formed through the third protective pattern structure 360 and a portion of the third semiconductor chip 300 adjacent to the second surface 314 thereof. Processes substantially the same as or similar to those illustrated with respect to FIG. 9 may be performed so that the third semiconductor chip 300 may be stacked on the second semiconductor chip 200 by a TCB process.

In some implementations, the third semiconductor chip 300 may include a third substrate 310 having first and second surfaces 312 and 314 opposite to each other in the vertical direction, and may be stacked on the second semiconductor chip 200 such that the bonding layer 700 covering a sixth insulating interlayer 330 on the first surface 312 of the third substrate 310 may contact the second protective pattern structure 260 on the second surface 214 of the second substrate 210. The third conductive connection member 350 of the third semiconductor chip 300 may be bonded with the fourth conductive pad 270 of the second semiconductor chip 300.

When the third semiconductor chip 300 is stacked on the second semiconductor chip 200, the trenches 800 on the second surface 214 of the second semiconductor chip 200 may not be filled with the bonding layer 700, however, a portion of the bonding layer 700 may move into the trenches 800 during the TCB process.

Likewise, the fourth semiconductor chip 400 including a fourth substrate 410 having first and second surfaces 412 and 414 opposite to each other in the vertical direction may be stacked on the third semiconductor chip 300, and the fourth conductive connection member 450 of the fourth semiconductor chip 400 may be bonded with the sixth conductive pad 370 of the third semiconductor chip 300. Additionally, the fifth semiconductor chip 500 including a fifth substrate 510 having first and second surfaces 512 and 514 opposite to each other in the vertical direction may be stacked on the fourth semiconductor chip 400, and the fifth conductive connection member 550 of the fifth semiconductor chip 500 may be bonded with the eighth conductive pad 470 of the fourth semiconductor chip 400.

Trenches 800 may also be formed on each of the third and fourth semiconductor chips 300 and 400, and may be filled with the bonding layer 700 during TCB processes.

Referring to FIGS. 1 and 2 again, a molding member 600 may be formed on the first wafer W1 to fill a space between structures each of which may include the second to fifth semiconductor chips 200, 300, 400 and 500.

In some implementations, the molding member 600 may expose an upper surface of the fifth semiconductor chip 500.

The first wafer W1 may be cut along the scribe lane region SA by, e.g., a sawing process to be singulated into a plurality of first semiconductor chips 100.

During the sawing process, the molding member 600 may also be cut to cover sidewalls of the second to fifth semiconductor chips 200, 300, 400 and 500 on each of the first semiconductor chips 100.

The first temporary bonding layer 910 and the first carrier substrate C1 may be separated from each of the first semiconductor chips 100 to complete the manufacturing the semiconductor package.

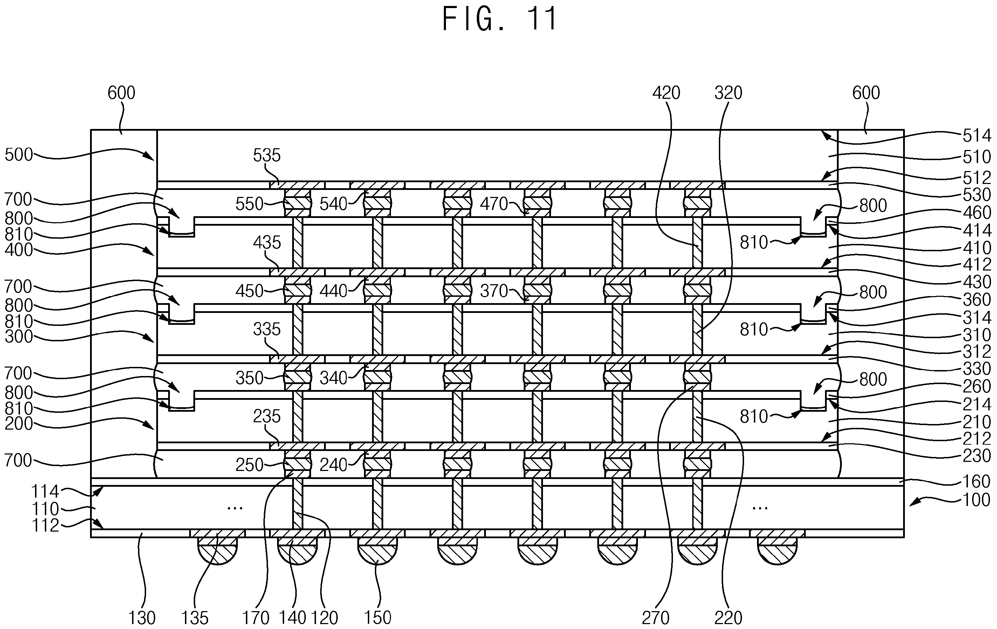

FIG. 11 is a cross-sectional view illustrating an example of a semiconductor package, which may correspond to FIG. 2. This semiconductor package may be substantially the same as or similar to that of FIGS. 1 and 2, except for further including a void, and thus repeated explanations are omitted herein.

Referring to FIG. 11, the trench 800 of each of the second to fourth semiconductor chips 200, 300 and 400 may not be entirely filled with the bonding layer 700, but a void 810 may be formed at a lower portion of the trench 800.

When the bonding layer 700 attached to an upper one of the semiconductor chips are stacked on a lower one of the semiconductor chips and the upper and lower ones of the semiconductor chips are bonded with each other, in some implementations, NCF or DAF included in the bonding layer 700 may expand but may not entirely fill the trench 800 on the lower one of the semiconductor chips.

If the void 810 is formed at the lower portion of the trench 800, when the semiconductor package is exposed to a high temperature, the void 810 may provide a space for NCF or DAF included in the bonding layer 700 may further expand so that stress applied to each semiconductor chip may be reduced.

FIG. 11 shows that the void 810 is formed at the trench 800 of each of the second to fourth semiconductor chips 200, 300 and 400, however, the present disclosure may not be limited thereto, and the void 810 may be formed at the trench 800 of some of the second to fourth semiconductor chips 200, 300 and 400 only.

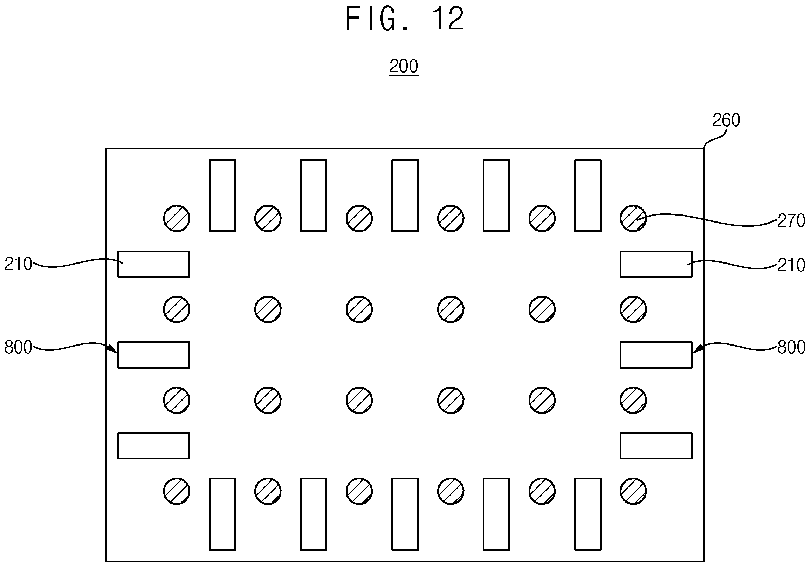

FIGS. 12 to 14 are plan views illustrating example layouts of trenches at each of the semiconductor chips.

FIGS. 12 to 14 show the layout of the trenches 800 at the second semiconductor chip 200, and the layout of the trenches 800 may also be applied the trenches 800 at each of the third and fourth semiconductor chip 300 and 400.

Referring to FIG. 12, each of the trenches 800 may have a shape of a rectangle extending toward a center of the second semiconductor chip 200 in a plan view, and an end portion of each of the trenches 800 may be disposed between the fourth conductive pads 270.

The trenches 800 of FIG. 2 is disposed at an edge portion of the second semiconductor chip 200 and surround the fourth conductive pads 270, while the trenches 800 of FIG. 12 extends to a portion of the second semiconductor chip 200 between the fourth conductive pads 270.

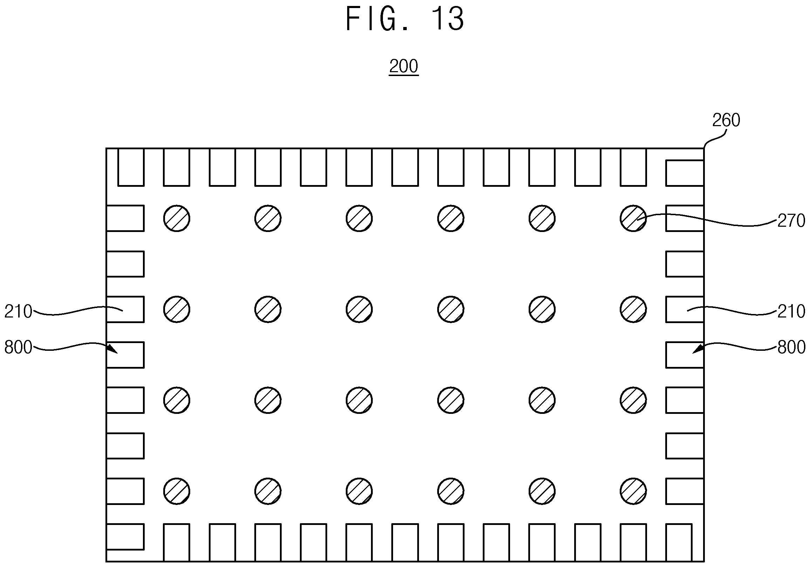

Referring to FIG. 13, an end portion of each of the trenches 800 may be aligned with a sidewall of the second semiconductor chip 200.

Each of the trenches 800 of FIG. 2 is spaced apart from a sidewall of the second substrate 210 of the second semiconductor chip 200 in the horizontal direction, while an end portion of each of the trenches 800 of FIG. 13 may be aligned with a sidewall of the second substrate 210 of the second semiconductor chip 200 in the vertical direction, and thus in a plan view, each of a sidewall of the second substrate 210 may not a shape of a line but a shape of a saw tooth in a plan view.

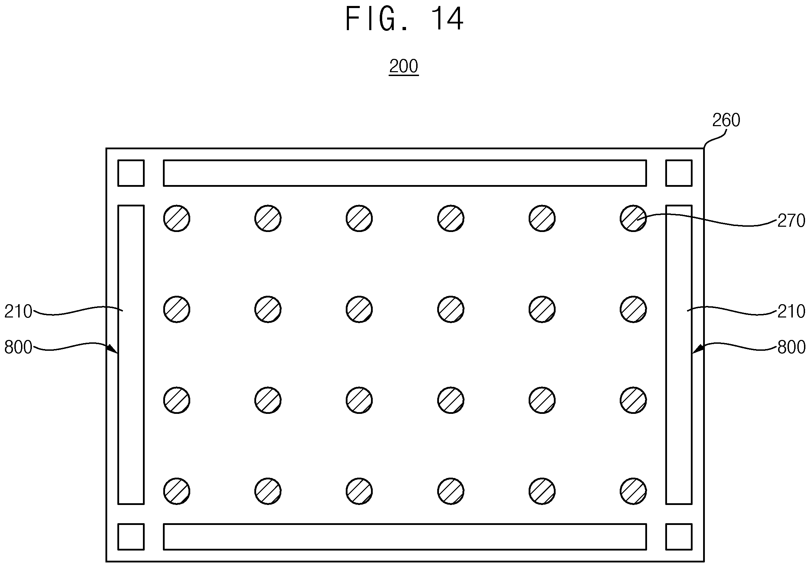

Referring to FIG. 14, the trench 800 at each of edge portions of the second semiconductor chip 200 may have a shape of a rectangle extending in an extension direction of a neighboring sidewall of the second semiconductor chip 200.

Additionally, the trenches 800 may be further formed at respective corners of the second semiconductor chip 200.

FIGS. 12 to 14 show the layouts of the trenches 800 of each of the semiconductor chips, however, the present disclosure may not be limited thereto, and the layouts of the trenches 800 may have other variations.

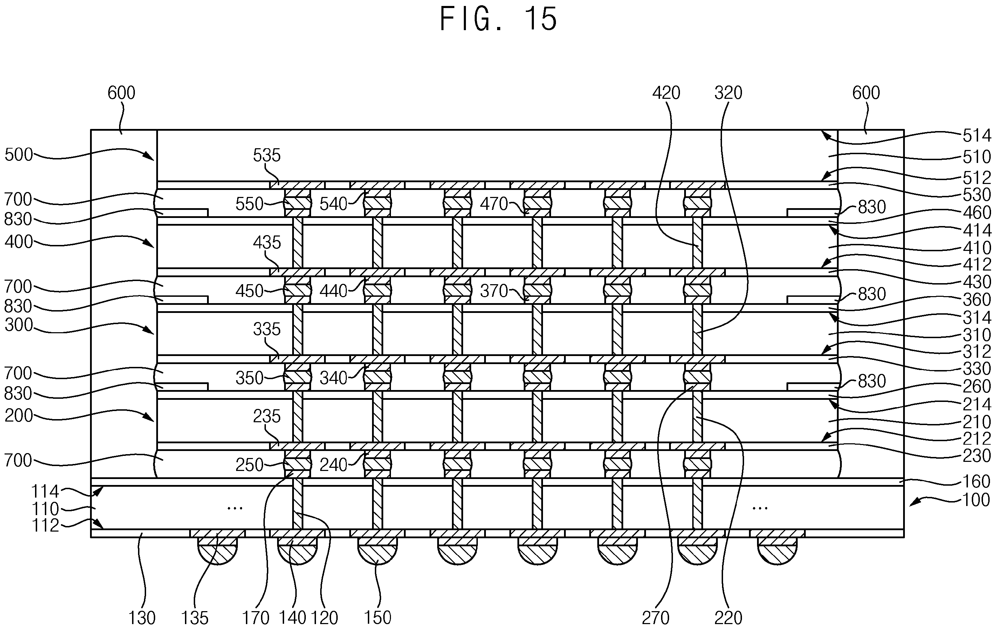

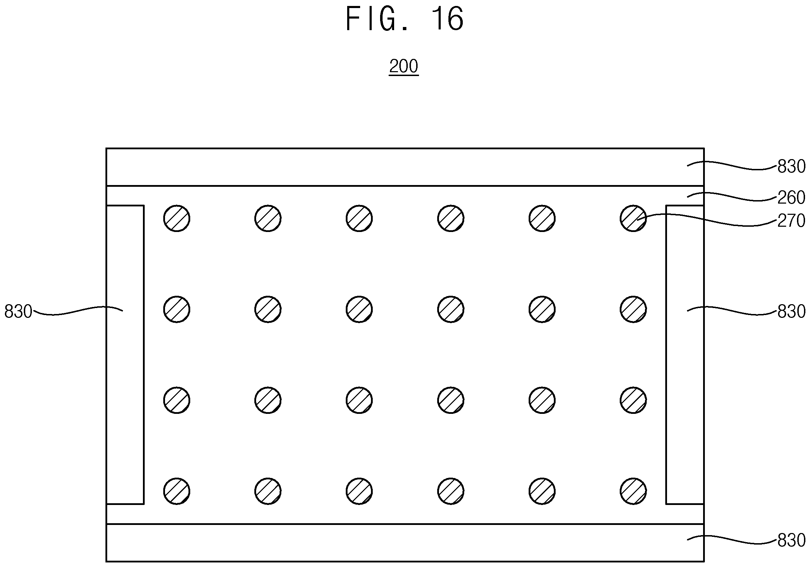

FIGS. 15 and 16 are a cross-sectional view and a plan view illustrating an example of a semiconductor package, which may correspond to FIGS. 1 and 2, respectively. This semiconductor package may be substantially the same as or similar to that of FIGS. 1 and 2, except for including dummy pads instead of the trenches, and thus repeated explanations are omitted herein.

Referring to FIGS. 15 and 16, dummy pads 830 may be formed on the second to fourth protective pattern structures 260, 360 and 460 included in the second to fourth semiconductor chips 200, 300 and 400, respectively.

Hereinafter, only the dummy pads 830 in the second semiconductor chip 200, however, the present disclosure may not be limited thereto, and the present disclosure may also be applied to the dummy pads 830 in each of the third and fourth semiconductor chips 300 and 400.

In some implementations, the dummy pads 830 may be formed at edge portions, respectively, of the second semiconductor chip 200, and may surround the fourth conductive pads 270 in a plan view. In some implementations, each of the dummy pads 830 may have a shape of a rectangle extending in a direction in a plan view. Each of the dummy pads 830 may have a horizontal width of about 1um to about 100um.

In some implementations, a sidewall of each of the dummy pads 830 may be aligned with a sidewall of the second semiconductor chip 200.

FIG. 16 shows that a single dummy pad 830 is formed at each of the edge portions of the second semiconductor chip 200, however, the present disclosure may not be limited thereto, and a plurality of dummy pads 830 may be formed in the horizontal direction at each of the edge portions of the second semiconductor chip 200.

In some implementations, the dummy pad 830 may include a non-conductive material having a CTE less than that of NCF or DAF included in the bonding layer 700, which may be a semiconductor material, e.g., silicon.

As illustrated above with reference to FIGS. 1 and 2, NCF or DAF included in the bonding layer 700 and silicon included in each of the semiconductor chips may have different CTEs from each other, and when the semiconductor package is exposed to a high temperature, cracks may be generated at the edge portion of each of the semiconductor chips or delamination may occur at an interface between the bonding layer 700 and each of the semiconductor chips due to the concentration of the stress.

However, in some implementations, the dummy pad 830 may be further formed on the edge portions of each of the semiconductor chip, so that the stress may be dispersed to the dummy pad 830. Accordingly, the generation of the cracks at the edge portion of each of the semiconductor chips due to the stress concentration may be prevented or relieved.

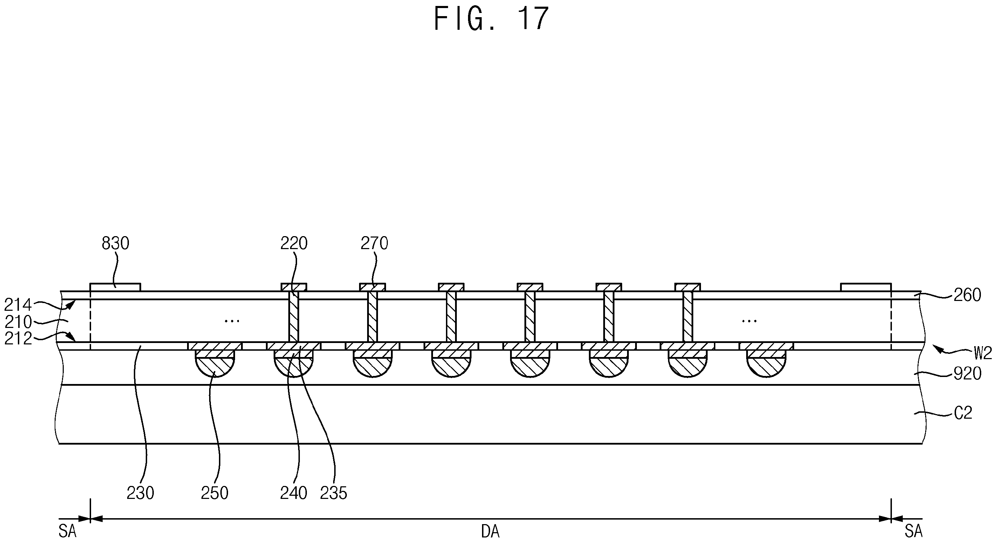

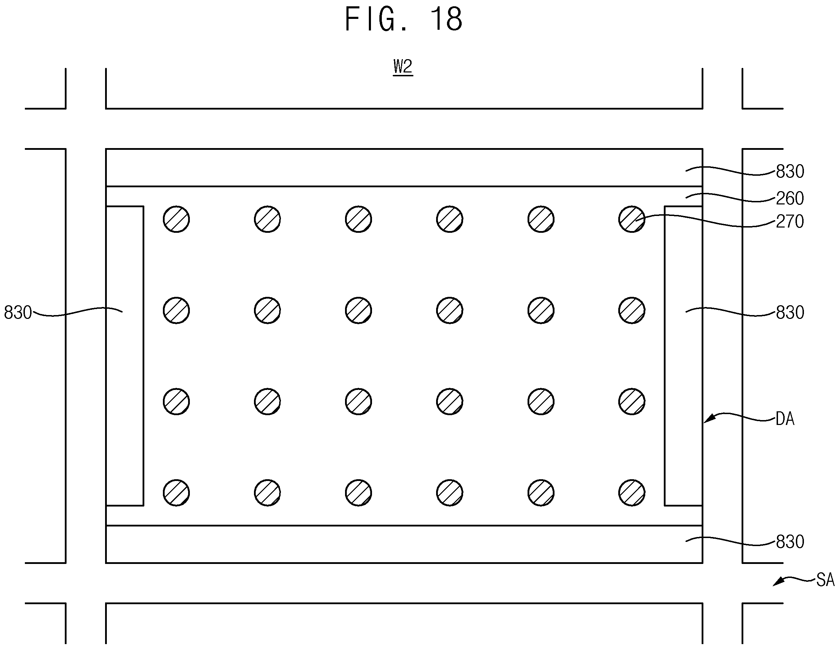

FIGS. 17 and 18 are a cross-sectional view and a plan view illustrating an example of a method of manufacturing a semiconductor package. This method may include processes substantially the same as or similar to those illustrated with respect to FIGS. 3 to 10 and FIGS. 1 and 2, and thus repeated explanations are omitted herein.

First, processes substantially the same as or similar to those illustrated with respect to FIGS. 3 to 6 may be performed.

Referring to FIGS. 17 and 18, a dummy pad 830 may be formed on the second protective pattern structure 260.

In some implementations, the dummy pad 830 may be formed to extend in a direction at each of edge portions of each of the die regions DA of the second wafer W2. Thus, the dummy pads 830 may be formed to surround the fourth conductive pads 270 in a plan view.

Processes substantially the same as or similar to those illustrated with respect to FIGS. 9 and 10 and FIGS. 1 and 2 may be performed to complete the manufacturing the semiconductor package.

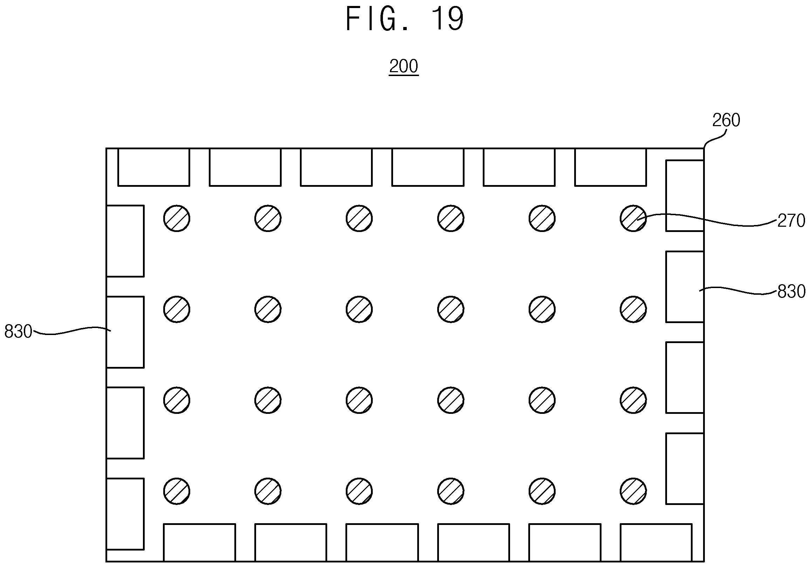

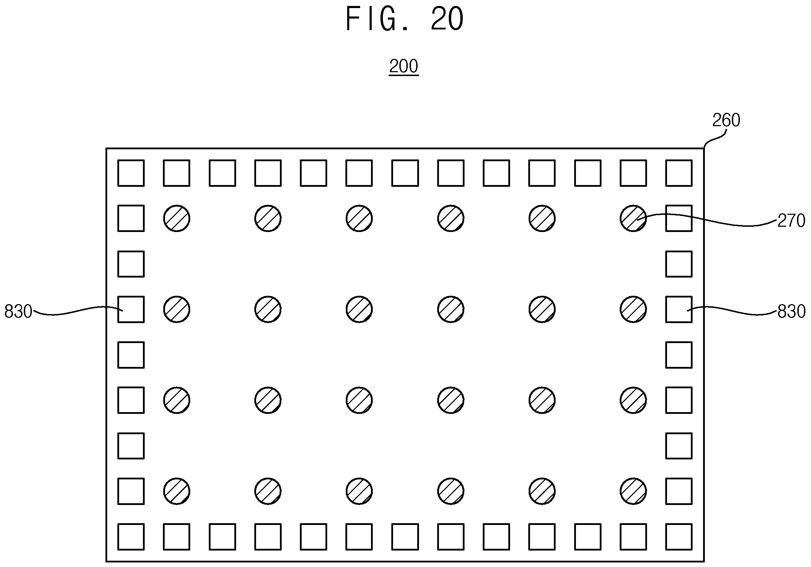

FIGS. 19 and 20 are plan views illustrating example layouts of dummy pads at each of the semiconductor chips.

FIGS. 19 and 20 show the layout of the dummy pads 830 at the second semiconductor chip 200, and the layout of the dummy pads 830 may also be applied the dummy pads 830 at each of the third and fourth semiconductor chip 300 and 400.

Referring to FIG. 19, a plurality of dummy pads 830 may be spaced apart from each other in the horizontal direction at each of edge portions of the second semiconductor chip 200.

A single dummy pad 830 may be formed at each of edge portions of the second semiconductor chip 200 in FIG. 17, while a plurality of dummy pads 830 may be spaced apart from each other in the horizontal direction at each of edge portions of the second semiconductor chip 200 in FIG. 19.

Referring to FIG. 20, each of a plurality of dummy pads 830 at each of the edge portions of the second semiconductor chip 200 may be spaced apart from a sidewall of the second semiconductor chip 200.

A sidewall of each of the dummy pads 830 in FIG. 17 may be aligned with a sidewall of the second semiconductor chip 200 in the vertical direction, while a sidewall of each of the dummy pads 830 in FIG. 20 may be spaced apart from the sidewall of the second semiconductor chip 200 in a plan view.

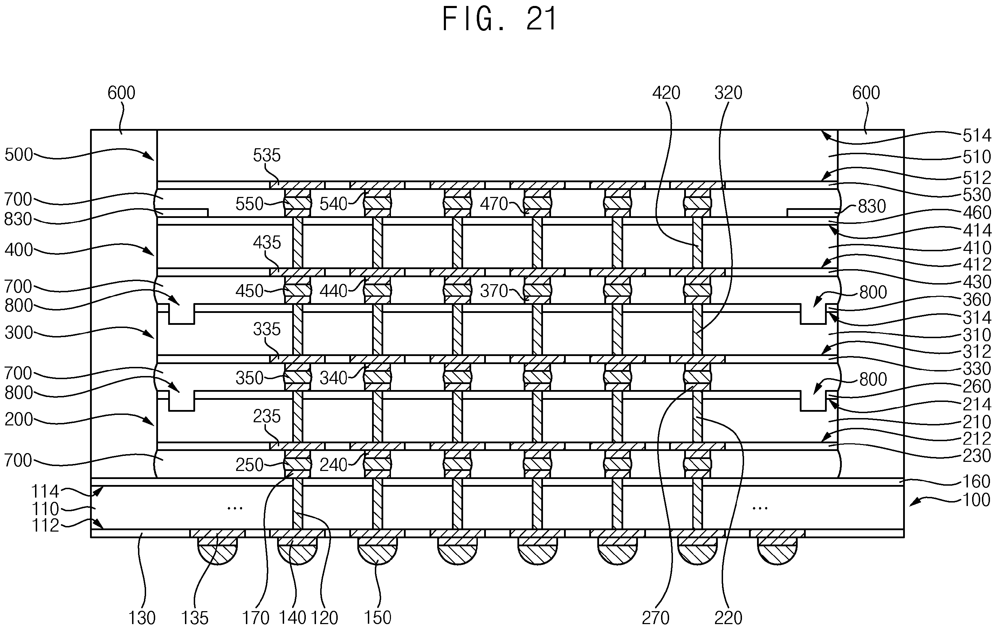

FIG. 21 is a cross-sectional view illustrating an example of a semiconductor package, which may correspond to FIG. 1 or FIG. 15. This semiconductor package may be substantially the same as or similar to that of FIGS. 1 and 2 or FIGS. 15 and 16, except for the trench or the dummy pad, and thus repeated explanations are omitted herein.

Referring to FIG. 21, the semiconductor package may include the trenches 800 on some of the semiconductor chips and the dummy pads 803 on others of the semiconductor chips.

That is, the semiconductor package may include both the trenches 800 of FIGS. 1 and 2 and the dummy pads 830 of FIGS. 15 and 16, and FIG. 21 shows that the trenches 800 are formed on each of the second and third semiconductor chips 200 and 300 and the dummy pads 830 are formed on the fourth semiconductor chip 400, however, the present disclosure may not be limited thereto.

When a plurality of core dies are stacked on a buffer die, the trenches 800 may be formed on some of the core dies, particularly, some of the middle core dies, and the dummy pads 830 may be formed on others of the middle cored dies. The trenches 800 and the dummy pad 830 may be alternately stacked in the vertical direction, or the trenches 800 may be formed on lower ones of the middle core dies and the dummy pads 830 may be formed on upper ones of the middle core dies, or vice versa.

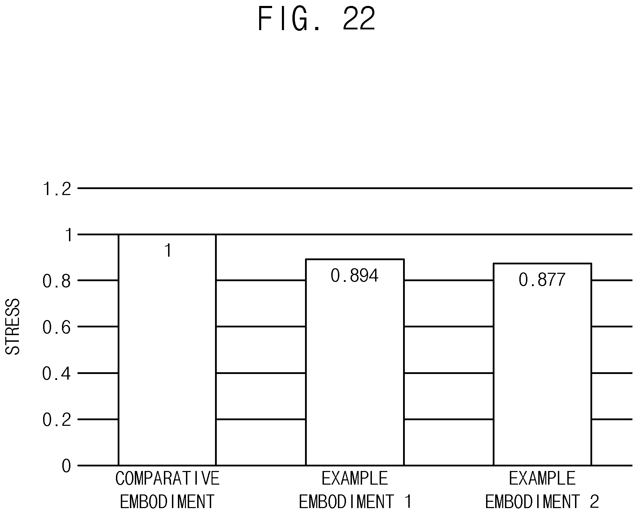

FIG. 22 is bar graphs illustrating magnitudes of stresses applied to each semiconductor chip in the example semiconductor packages of comparative implementations, example implementation 1 and example implementation 2, respectively.

In FIG. 22, the trenches are formed on each semiconductor chip in example implementation 1, the dummy pads are formed on each semiconductor chip in example implementation 2, and neither the trenches nor the dummy pads are formed on each semiconductor chip in comparative implementation.

Referring to FIG. 22, when the semiconductor packages are exposed to a high temperature, a magnitude of stress applied to each semiconductor chip is reduced by about 10.6% in example implementation 1, and a magnitude of stress applied to each semiconductor chip is reduced by about 12.6% in example implementation 2, when compared to that of comparative implementation.

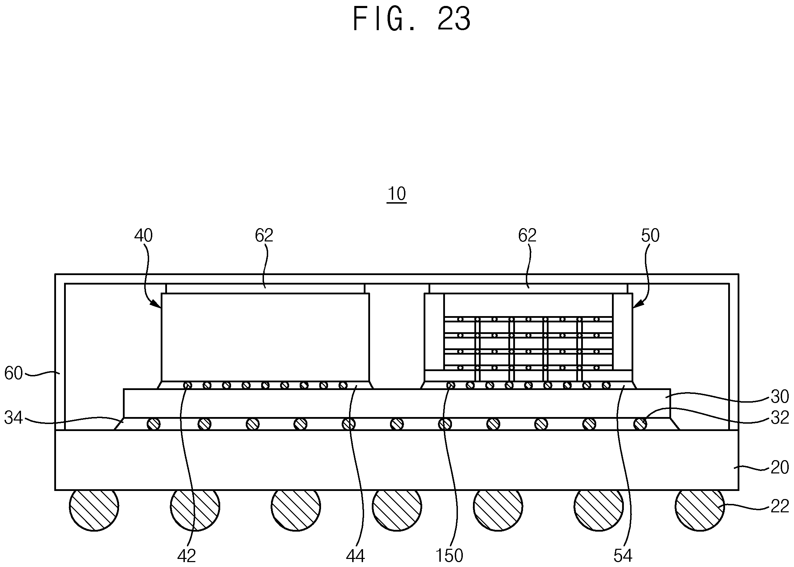

FIG. 23 is a cross-sectional view illustrating an example of an electronic device.

This electronic device may include the semiconductor package shown in FIGS. 1 and 2 as a second semiconductor device 50, however, the present disclosure may not be limited thereto, and for example, the electronic device may include one of the semiconductor packages shown in FIGS. 15 and 16 or FIG. 21 as the second semiconductor device 50.

Referring to FIG. 23, an electronic device 10 may include a package substrate 20, an interposer 30, a first semiconductor device 40 and the second semiconductor device 50. The electronic device 10 may further include first, second and third underfill members 34, 44 and 54, a heat slug 60 and a heat dissipation member 62.

In some implementations, the electronic device 10 may be a memory module having a 2.5D package structure, and thus may include the interposer 30 for electrically connecting the first and second semiconductor devices 40 and 50 to each other.

In some implementations, the first semiconductor device 40 may include a logic device, and the second semiconductor device 50 may include a memory device. The logic device may be an application-specific integrated circuit (ASIC) chip including, e.g., a central processing unit (CPU), a graphics processing unit (GPU), a micro-processor, a microcontroller, an application processor (AP), a digital signal processing core, etc. The memory device may be a semiconductor package such as an HBM package.

In some implementations, the package substrate 20 may have an upper surface and a lower surface opposite to each other in the vertical direction. For example, the package substrate 20 may be a printed circuit board (PCB). The printed circuit board may be a multi-layer circuit board having various circuits therein.

The interposer 30 may be mounted on the package substrate 20 through a seventh conductive connection member 32. In some implementations, a planar area of the interposer 30 may be smaller than a planar area of the package substrate 20. The interposer 30 may be disposed within an area of the package substrate 20 in a plan view.

The interposer 30 may be a silicon interposer or a redistribution interposer having a plurality of wirings therein. The first semiconductor device 40 and the second semiconductor device 50 may be connected to each other through the wirings in the interposer 30 or electrically connected to the package substrate 20 through the seventh conductive connection member 32. The seventh conductive connection member 32 may include, e.g., a micro-bump. The silicon interposer may provide a high-density interconnection between the first and second semiconductor devices 40 and 50.

The first semiconductor device 40 may be disposed on the interposer 30. The first semiconductor device 40 may be mounted on and bonded with the interposer 30 by a flip chip bonding process. In this case, the first semiconductor device 40 may be mounted on the interposer 30 such that an active surface on which conductive pads are formed may face downwardly toward the interposer 30. The conductive pads of the first semiconductor device 40 may be electrically connected to conductive pads of the interposer 30 through an eighth conductive connection member 42. For example, the eighth conductive connection member 42 may include, e.g., a micro-bump.

Alternatively, the first semiconductor device 40 may be mounted on the interposer 30 by a wire bonding process, and in this case, the active surface of the first semiconductor device 40 may face upwardly.

The second semiconductor device 50 may be disposed on the interposer 30, and may be spaced apart from the first semiconductor device 40 in the horizontal direction. The second semiconductor device 50 may be mounted on and bonded with the interposer 30 by, e.g., a flip chip bonding process. In this case, conductive pads of the second semiconductor device 50 may be electrically connected to conductive pads of the interposer 30 by the first conductive connection member 150.

Although a single first semiconductor device 40 and a single second semiconductor device 50 are disposed on the interposer 30, however, the present disclosure may not be limited thereto, and a plurality of first semiconductor devices 40 and/or a plurality of second conductive devices 50 may be disposed on the interposer 30.

In some implementations, the first underfill member 34 may fill a space between the interposer 30 and the package substrate 20, and the second and third underfill members 44 and 54 may fill a space between the first semiconductor device 40 and the interposer 30 and a space between the second semiconductor device 50 and the interposer 30, respectively.

The first to third underfill members 34, 44 and 54 may include a material having a relatively high fluidity to effectively fill a small space between the first and second semiconductor devices 40 and 50 and the interposer 30 and a small space between the interposer 30 and the package substrate 20. For example, each of the first and second underfill members 34, 44 and 54 may include an adhesive containing an epoxy material.

The semiconductor device 50 may include a buffer die and a plurality of memory dies sequentially stacked on the buffer die. The buffer die and the memory dies may be electrically connected to each other by through electrodes, e.g., TSVs, and the through electrodes may be electrically connected to each other by conductive connection members. Data signals and control signals may be transferred to the buffer die and the memory dies by the through electrodes.

In some implementations, the heat slug 60 may be formed on the package substrate 20 to thermally contact the first and second semiconductor devices 40 and 50. The heat dissipation member 62 may be disposed on an upper surface of each of the first and second semiconductor devices 40 and 50, and may include, e.g., thermal interface material (TIM). The heat slug 60 may thermally contact the first and second semiconductor devices 40 and 50 via the heat dissipation member 62.

A conductive pad may be formed at a lower portion of the package substrate 20, and a sixth conductive connection member 22 may be disposed beneath the conductive pad. In some implementations, a plurality of sixth conductive connection members 22 may be spaced apart from each other in the horizontal direction. The sixth conductive connection member 22 may be, e.g., a solder ball. The electronic device 10 may be mounted on a module board via the sixth conductive connection members 22 to form a memory module.

## Claims

1. A semiconductor package comprising:
a first semiconductor chip (100);
a plurality of second semiconductor chips (200, 300, 400) stacked on the first semiconductor chip in a vertical direction;
a bonding layer (700) between the plurality of second semiconductor chips; and
a molding member (600) on the first semiconductor chip, the molding member covering a plurality of sidewalls of the plurality of second semiconductor chips and the bonding layer,
wherein a trench (800) is positioned on at least one of the plurality of second semiconductor chips, and
wherein the bonding layer at least partially fills the trench.

2. The semiconductor package according to claim 1, wherein the bonding layer (700) entirely fills the trench.

3. The semiconductor package according to claim 1, wherein the bonding layer (700) partially fills the trench, and a void (810) is positioned in the trench.

4. The semiconductor package according to claim 1, wherein the trench (800) is positioned on an edge portion of the at least one of the plurality of second semiconductor chips (200, 300, 400).

5. The semiconductor package according to claim 4, comprising a plurality of trenches (800) spaced apart from each other in a horizontal direction on the edge portion of the at least one of the plurality of second semiconductor chips (200, 300, 400).

6. The semiconductor package according to claim 4, wherein the trench (800) is spaced apart from a sidewall of the at least one of the plurality of second semiconductor chips (200, 300, 400), the sidewall being adjacent to the edge portion of the at least one of the plurality of second semiconductor chips (200, 300, 400).

7. The semiconductor package according to claim 4, wherein an end portion of the trench (800) is aligned with a sidewall of the at least one of the plurality of second semiconductor chips (200, 300, 400) in the vertical direction.

8. The semiconductor package according to claim 1, wherein the at least one of the plurality of second semiconductor chips (200, 300, 400) includes:
a substrate (210, 310, 410);
a through electrode (220, 320, 420) extending through the substrate and including a protrusion portion, wherein the protrusion portion protrudes in the vertical direction over an upper surface of the substrate (210, 310, 410); and
a protective pattern structure (260, 360, 460) covering a sidewall of the protrusion portion of the through electrode (220, 320, 420),
wherein the trench (800) extends through the protective pattern structure (260, 360, 460) and an upper portion of the substrate (210, 310, 410).

9. The semiconductor package according to claim 1, wherein the bonding layer (700) includes non-conductive film (NCF) or die attach film (DAF), and the molding member (600) includes epoxy molding compound (EMC).

10. A semiconductor package comprising:
a first semiconductor chip (100);
a plurality of second semiconductor chips (200, 300, 400) stacked on the first semiconductor chip in a vertical direction;
a bonding layer (700) between the plurality of second semiconductor chips; and
a molding member (600) on the first semiconductor chip, the molding member covering a plurality of sidewalls of the plurality of second semiconductor chips and the bonding layer,
wherein at least one of the plurality of second semiconductor chips includes a dummy pad (830) thereon, the dummy pad including a non-conductive material having a coefficient of thermal expansion (CTE) less than a CTE of the bonding layer, and
wherein the bonding layer (700) covers the dummy pad.

11. The semiconductor package according to claim 10, wherein the dummy pad (830) is disposed on an edge portion of the at least one of the plurality of second semiconductor chips (200, 300, 400).

12. The semiconductor package according to claim 11, wherein the dummy pad (830) is disposed on each of edge portions of the at least one of the plurality of second semiconductor chips (200, 300, 400), and the dummy pad extends in an extension direction of a sidewall of the at least one of the plurality of second semiconductor chips (200, 300, 400), the sidewall being adjacent to each of the edge portions thereof.

13. The semiconductor package according to claim 11, wherein a sidewall of the dummy pad (830) is aligned with a sidewall of the at least one of the plurality of second semiconductor chips (200, 300, 400) in the vertical direction.

14. The semiconductor package according to claim 10, wherein the dummy pad (830) includes silicon.

15. The semiconductor package according to claim 10, wherein the bonding layer (700) includes non-conductive film (NCF) or die attach film (DAF), and the molding member (600) includes epoxy molding compound (EMC).
